# EUROPEAN PATENT SPECIFICATION

(11) **EP 2 337 085 B1**
(45) Date of publication and mention of the grant of the patent: **26.03.2014**
(21) Application number: 09814558.4
(22) Date of filing: 14.09.2009
(51) Int. Cl.: H01L 31/04

(54) **INTEGRATED THIN FILM SOLAR CELL AND MANUFACTURING METHOD THEREFOR**
INTEGRIERTE DÜNNFILM-SOLARZELLE UND HERSTELLUNGSVERFAHREN DAFÜR
CELLULE SOLAIRE À COUCHES MINCES INTEGRÉES ET PROCÉDÉ DE FABRICATION ASSOCIÉ

(30) Priority: 22.09.2008 JP 2008242695
(43) Date of publication of application: 22.06.2011
(73) Proprietor: Sharp Kabushiki Kaisha, Osaka-shi, Osaka 545-8522 (JP)
(72) Inventor: TAKEDA, Tohru, c/o Sharp Kabushiki Kaisha, Osaka-shi, Osaka 545-8522 (JP); NASUNO, Yoshiyuki, c/o Sharp Kabushiki Kaisha, Osaka-shi, Osaka 545-8522 (JP)
(74) Representative: Müller - Hoffmann & Partner
(86) International application number: PCT/JP2009/066043
(87) International publication number: WO 2010/032713

(56) References cited:
- JP-A- 60 100 482
- JP-A- 2001 077 385
- JP-A- 2001 135 836
- JP-A- 2002 124 690
- JP-A- 2002 124 690
- JP-A- 2002 373 997
- JP-A- 2006 245 507
- US-A1- 2006 196 536

## Description

### TECHNICAL FIELD

The present invention relates to an integrated thin-film solar battery and a manufacturing method thereof.

### BACKGROUND ART

As a conventional technique, for example, Fig. 2 in Patent Document 1 discloses an integrated thin-film solar battery (hereinafter, it is occasionally abbreviated to a solar battery) having a string (battery string) where a plurality of thin-film photoelectric conversion elements are electrically connected in series.

In a conventional technique, the thin-film photoelectric conversion elements are configured so that a transparent electrode layer, a photoelectric conversion layer and a metal electrode layer are sequentially laminated on a transparent insulating substrate.

In this solar battery, the thin-film photoelectric conversion elements on both sides of a series-connecting direction are parallel-connection elements that are connected to the thin-film photoelectric conversion elements adjacent in a direction perpendicular to the series-connecting direction. A plurality of strings are electrically connected in parallel by these parallel-connection elements, and an electric power is extracted from the parallel-connection elements.

In this case, a constitution may be such that a power collecting electrode made of a metal line (for example, a copper line) is electrically jointed onto a metal electrode layer of each parallel-connection element via a brazing filler metal, and a large electric current is extracted by the metal electrode layer and the power collecting electrode.

The plurality of strings are formed on one substrate and are connected in parallel because of the following reason.

When one string is formed on the substrate and even one leak portion is present in any thin-film photoelectric conversion element (cell) in the string, an entire output of the string (the entire solar battery) is reduced. For this reason, the string is divided plurally. As a result, even when the output from the string where the cell leak portion is present is reduced, the entire output from the solar battery is prevented from being reduced.

Further, in this solar battery, the adjacent strings are insulated from each other by a string separating groove (an aperture groove for light) having a cross-sectional shape shown in Fig. 4 of Patent Document 1.

This string separating groove includes a first groove obtained by removing the transparent electrode layer and a second groove obtained by removing the photoelectric conversion layer and the metal electrode layer. When the thin-film photoelectric conversion elements are removed by a light beam, a width of the second groove is made to be wider than a width of the first groove so that the transparent electrode layer and the metal electrode layer are not shorted.

This string separating groove is formed as follows.

At first, a YAG fundamental wave light beam that can remove all the transparent electrode layer, the photoelectric conversion layer and the metal electrode layer at once is emitted to a rear surface (outer surface) of the transparent insulating substrate, so that the first groove that passes through the transparent electrode layer and the metal electrode layer is formed. Thereafter, the YAG fundamental wave light beam, whose intensity is adjusted so that only the photoelectric conversion layer and the metal electrode layer can be removed, is emitted to a region including the first groove via the rear surface of the transparent insulating substrate, so that the second groove with the larger width is formed.

### PRIOR ART DOCUMENTS

### PATENT DOCUMENT

Patent Document 1: Japanese Patent Application Laid-Open No. 2002-124690

US 2006/0196536 relates to a thin film solar cell and to a manufacturing method thereof.

### DISCLOSURE OF THE INVENTION

### PROBLEM TO BE SOLVED BY THE INVENTION

The string separating groove of this solar battery is formed by emitting the YAG fundamental wave light beam of different intensity to the transparent insulating substrate and simultaneously transferring the light beam to a series-connecting direction. At this time, the parallel-connection elements on both the sides that connected the plurality of strings in parallel were not divided, but an ON/OFF state of the light beam was controlled accurately so that the other thin-film photoelectric conversion elements therebetween were securely divided. In another manner, a portion that was not divided by the light beam was coated with a mask.

A method for controlling ON/OFF of the light beam is easier as a step than a method using a mask.

However, in the method for controlling ON/OFF of the light beam, while a beam emitting unit is being transferred to the series-connecting direction by a transfer mechanism, the ON/OFF state of the light beam emission is controlled so that a start point and an end point of the light beam are determined. For this reason, it was necessary to accurately control the ON/OFF state of the light beam on a predetermined position using a precise transfer mechanism that could accurately detect a position of the light beam. This case, therefore, has a disadvantage such that a cost of forming the string separating groove increases.

It is an object of the present invention to provide an integrated thin-film solar battery in which a string separating groove is formed by an easy and low-cost method and thus a plurality of strings are connected in parallel, and a manufacturing method thereof.

### MEANS FOR SOLVING THE PROBLEM

The above objects are solved by the claimed matter according to the independent claims.

Therefore, the present invention provides an integrated thin-film solar battery comprising:
a plurality of strings having a plurality of thin-film photoelectric conversion elements formed on a transparent insulating substrate, the thin-film photoelectric conversion elements being electrically connected in series to each other, wherein
the thin-film photoelectric conversion elements have a first transparent electrode layer laminated on the transparent insulating substrate, a photoelectric conversion layer laminated on the first electrode layer and a second electrode layer laminated on the photoelectric conversion layer,
the plurality of strings are arranged in parallel on the same transparent insulating substrate in a direction perpendicular to the series-connecting direction across one or more string separating grooves extending to the series-connecting direction,
the string separating groove includes a first groove formed by removing the first electrode layer, and a second groove formed by removing the photoelectric conversion layer and the second electrode layer with a width wider than that of the first groove,
the thin-film photoelectric conversion elements on any position in the series-connecting direction are parallel-connection elements some of which are removed by the string separating groove and residual ones of which are connected integrally so as to extend to the direction perpendicular to the series-connecting direction, and the parallel-connection elements electrically connect the plurality of strings in parallel.

Further, another aspect of the present invention provides a method for manufacturing an integrated thin-film solar battery, comprising:
a pre-division string forming step of forming a pre-division string on a surface of a transparent insulating substrate, the pre-division string having a plurality of thin-film photoelectric conversion elements electrically connected to each other in series; and
a string dividing step of removing a predetermined portion of the pre-division string using a light beam and forming a string separating groove extending to a series-connecting direction so as to form a plurality of strings, wherein
the pre-division string forming step includes a depositing step of laminating a first electrode layer, a photoelectric conversion layer and a second electrode layer on the surface of the transparent insulating substrate in this order so as to form a laminated film, and a step of removing the second electrode layer and the photoelectric conversion layer from the laminated film to form a plurality of element separating grooves extending to a direction perpendicular to the series-connecting direction so as to form the plurality of thin-film photoelectric conversion elements,
the string separating groove includes a first groove formed by removing the first electrode layer and a second groove formed by removing the photoelectric conversion layer and the second electrode layer with a width wider than that of the first groove, and
at the string dividing step, the pre-division string is partially removed by a light beam so that the string separating groove is formed only on some of any thin-film photoelectric conversion elements extending to the direction perpendicular to the series-connecting direction, thereby forming the plurality of strings arranged in parallel in the direction perpendicular to the series-connecting direction and parallel-connection elements for electrically connecting the plurality of strings in parallel.

### EFFECT OF THE INVENTION

In the present invention, any thin-film photoelectric conversion elements adjacent in the direction perpendicular to the series-connecting direction are parallel-connection elements some of which are removed by the string separating grooves and the residual ones of which are connected. The plurality of strings are formed in a manner that the other thin-film photoelectric conversion elements adjacent in the same direction are separated by the string separating grooves.

According to the present invention, the string separating groove may be formed so as to remove some of the parallel-connection elements for connecting the plurality of strings in parallel. That is to say, since a difficulty that all the parallel-connection elements should not be removed is eliminated, an allowable range of forming end portions of the string separating grooves is widened.

Therefore, the string separating groove is formed by a simple method for controlling a transfer of a light beam with a certain level of accuracy without accurately controlling the ON/OFF state of the light beam at the time of forming the string separating groove, thereby providing the integrated thin-film solar battery where the plurality of strings are connected in parallel.

### BRIEF DESCRIPTION OF THE DRAWINGS

Fig. 1 is a plan view illustrating an integrated thin-film solar battery according to an embodiment 1 of the present invention;
Fig. 2(a) is a cross-sectional view taken along a line I-I of Fig. 1, Fig. 2(b) is a side view when the integrated thin-film solar battery in Fig. 1 is viewed from a series-connecting direction, and Fig. 2(c) is a cross-sectional view taken along a line II-II in Fig. 1;
Fig. 3(a) is a cross-sectional view taken along a line III-III in Fig. 1, Fig. 3(b) is a plan view illustrating a vicinity of a string separating groove of the integrated thin-film solar battery in Fig. 1;
Fig. 4(a) is a partial cross-sectional view illustrating a vicinity of the string separating groove of the integrated thin-film solar batter in the series-connecting direction according to an embodiment 2, and Fig. 4(b) is a partial plan view illustrating the vicinity of the string separating groove of the integrated thin-film solar batter according to the embodiment 2;
Fig. 5(a) is a partial cross-sectional view illustrating the vicinity of the string separating groove of the integrated thin-film solar battery in the sires-connecting direction according to an embodiment 3, and Fig. 5(b) is a partial plan view illustrating the vicinity of the string separating groove of the integrated thin-film solar battery according to the embodiment 3;
Fig. 6 is a plan view illustrating the integrated thin-film solar battery according to an embodiment 4 of the present invention;
Fig. 7 is a plan view illustrating the integrated thin-film solar battery according to an embodiment 5 of the present invention;
Fig. 8(a) is a partial cross-sectional view illustrating the vicinity of the string separating groove of the integrated thin-film solar battery in the series-connecting direction according to the embodiment 5, and Fig. 8(b) is a partial plan view illustrating the vicinity of the string separating groove of the integrated thin-film solar battery according to the embodiment 5; and
Fig. 9(a) is a partial cross-sectional view illustrating the vicinity of the string separating groove of the integrated thin-film solar battery in the series-connecting direction according to an embodiment 6, and Fig. 9 (b) is a partial plan view illustrating the vicinity of the string separating groove of the integrated thin-film solar battery according to the embodiment 6.

### MODE FOR CARRYING OUT THE INVENTION

An integrated thin-film solar battery according to embodiments of the present invention is described in detail below with reference to the drawings. The embodiments are examples of the present invention, and the present invention is not limited to the embodiments.

### (Embodiment 1)

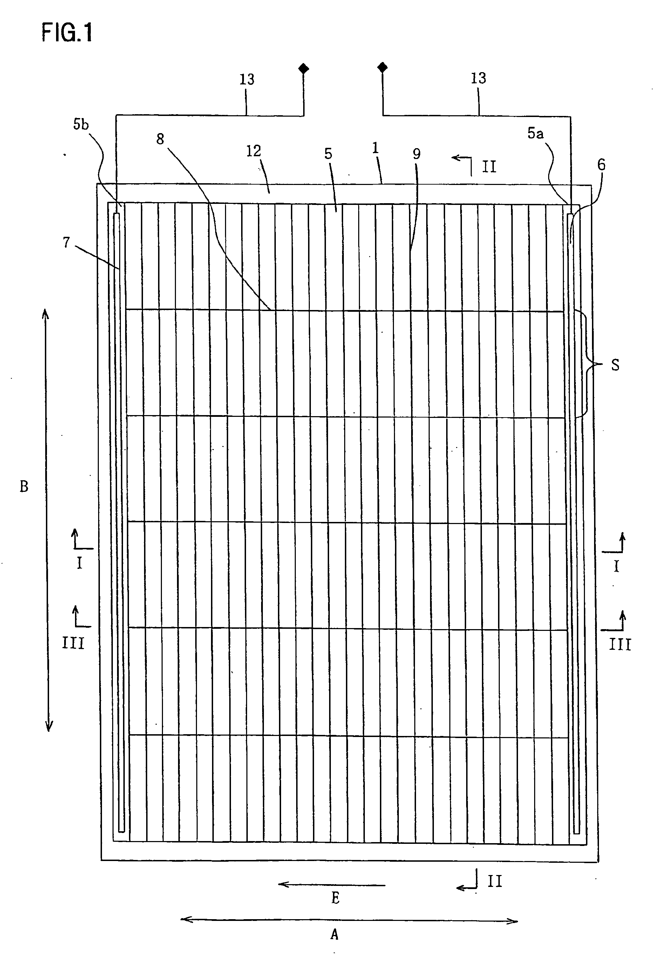

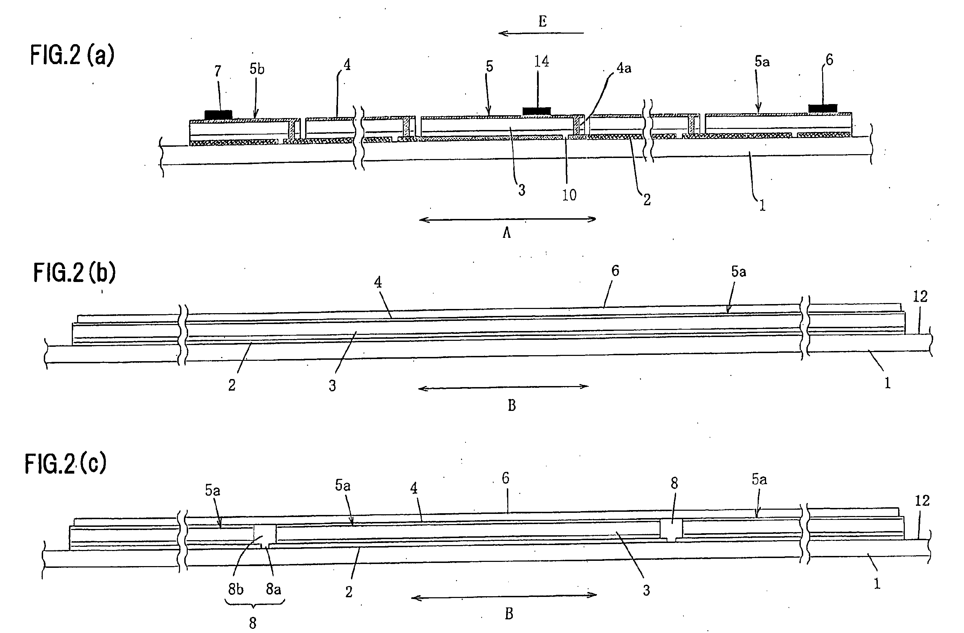

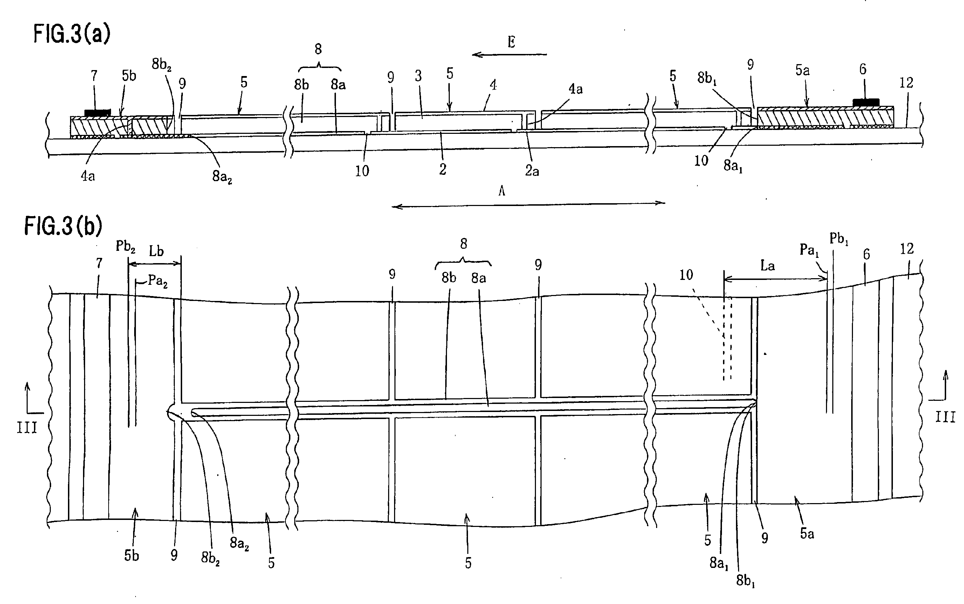

Fig. 1 is a plan view illustrating the integrated thin-film solar battery according to an embodiment 1 of the present invention. Fig. 2(a) is a cross-sectional view taken along a line I-I in Fig. 1, Fig. 2(b) is a side view where the integrated thin-film solar battery in Fig. 1 is viewed from a series-connecting direction, and Fig. 2(c) is a cross-sectional view taken along a line II-II in Fig. 1. Further, Fig. 3(a) is a cross-sectional view taken along a line III-III in Fig. 1, and Fig. 3(b) is a plan view illustrating a vicinity of the string separating groove of the integrated thin-film solar battery in Fig. 1.

In Figs. 1 to 3, an arrow E represents a flowing direction of an electric current (current direction), and when simple description of "an upper stream" or "a lower stream" in this specification means an upper stream or a lower stream in the current direction.

In Figs. 1 to 3, an arrow A shows the series-connecting direction, and means a direction where a plurality of thin-film photoelectric conversion elements that are connected and arranged in series.

Further, in Figs. 1 to 3, an arrow B represents a direction that is perpendicular to the series-connecting direction.

This integrated thin-film solar battery includes a square transparent insulating substrate 1, a string S including a plurality of thin-film photoelectric conversion elements 5 that are formed on the insulating substrate 1 and are electrically connected in series to each other, one first power collecting electrode 6 and one second power collecting electrode 7 that are electrically jointed onto a second electrode layer 4 of thin-film photoelectric conversion elements 5a and 5b on both ends of the series-connecting direction A in the string S via a brazing filler metal.

The thin-film photoelectric conversion elements 5 are configured so that a transparent first electrode layer 2, a photoelectric conversion layer 3 and the second electrode layer 4 are laminated on the insulating substrate 1 in this order.

As the first and second power collecting electrodes 6 and 7, for example, a copper line, a solder plating copper line or the like is used.

Hereinafter, "the integrated thin-film solar battery" is abbreviated to "the solar battery" as described above, and "the thin-film photoelectric conversion element" is called as "a cell" is some cases.

Further, in this solar battery, a plurality of strings S (in this case, 6) are arranged on the same insulating substrate 1 in parallel in the direction B perpendicular to the series-connecting direction via a plurality of string separating grooves 8 (in this case, 5) extending to the series-connecting direction A.

### <String>

As shown in Figs. 1 and 2(a), the string S has an element separating groove 9 that is formed by removing the second electrode layer 4 and the photoelectric conversion layer 3 between the adjacent two cells (thin-film photoelectric conversion elements) 5.

This element separating groove 9 extends to the direction of the arrow B so that the second electrode 4 and the photoelectric conversion layer 3 of the one cell 5 are electrically separated from the second electrode 4 and the photoelectric conversion layer 3 of the other adjacent cell 5. A width of the element separating groove 9 (the direction of the arrow A) is preferably about 30 to 80 µm.

In this string S, the first electrode layer 2 of the one cell 5 has an extending section 2a whose one end (a lower-stream side end portion in the current direction E) acrosses the element separating groove 9 and that extends to a region of the other adjacent cell 5, and is electrically insulated from the adjacent first electrode layer 2 by an electrode separating line 10.

Further, one end (upper-stream side end portion in the current direction E) of the second electrode layer 4 of the one cell 5 is electrically connected to the extending section 2a of the first electrode layer 2 of the adjacent cell 5 via a series-connection conductive section 4a passing through the photoelectric conversion layer 3. The conductive section 4a can be formed integrally with the second electrode layer 4 by the same step and the same material.

Further, in the plurality of strings S, cells 5a and 5b that are jointed to the first and second power collecting electrodes 6 and 7 are connected as shown in Figs. 1 and 2(b).

In this case, the string separating groove 8 does not completely separate the adjacent two strings S. That is to say, the cells 5a and 5b on the both ends in the direction of the arrow A extend long to the direction of the arrow B, and thus the both ends of all the strings S are electrically connected in parallel to the first and second power collecting electrodes 6 and 7 via the common second electrode 4.

That is to say, the cells 5a and 5b on the both ends are parallel-connection elements for electrically connecting the plurality of strings S in parallel.

The string separating groove 8 includes a first groove 8a formed by removing the first electrode layer 2, and a second groove 8b formed by removing the photoelectric conversion layer 3 and the second electrode layer 4 with a width wider than that of the first groove 8a. This string separating groove 8 prevents the short circuit between the first electrode layer 2 and the second electrode layer 4 of each cell. A width of the first groove 8a (the direction of the arrow B) is preferably about 10 to 1000 µm, and a width of the second groove 8b (the direction of the arrow B) is preferably about 20 to 1500 µm.

As shown in Figs. 3(a) and (b), in the plurality of strings, any cells extending to the direction B perpendicular to the series-connecting direction A, namely, the two cells 5a and 5b jointed to the first and second power collecting electrodes 6 and 7 are partially removed by the string separating groove 8 and their residual portions may be connected integrally.

Concretely, an end portion 8a₁ of the first groove 8a on the upper-stream side of the current direction E is arranged on the upper-stream side with respect to the first electrode layer 2 of the cell 5 adjacent to the lower-stream side of the cell 5a as the upper-stream side parallel element. As a result, the first electrode layers 2 of the plurality of cells 5 (the direction B) adjacent to the cell 5a are completely insulated and separated by the first groove 8a.

In the embodiment 1, since the end portion 8a₁ of the first groove 8a is arranged within a region of the element separating groove 9 adjacent to the cell 5a, the first electrode layer 2 of the cell 5a is partially removed.

A position of the end portion 8a₁ of the first groove 8a can shift to a region of the electrode separating line 10 for insulating and separating the first electrode layer 2 of the cell 5 adjacent to the first electrode layer 2 of the cell 5a.

Further, an end portion 8b₂ of the second groove 8b on the lower-stream side of the current direction E is arranged on the lower-stream side with respect to the second electrode layer 4 of the cell 5 adjacent to the upper-stream side of the cell 5b as the lower-stream side parallel element. As a result, the second electrode layer 4 and the photoelectric conversion layer 3 of the plurality of cells 5 (direction B) adjacent to the cell 5b are completely insulated and separated by the second groove 8b.

In the embodiment 1, since the end portion 8b₂ of the second groove 8b is positioned near the element separating grove 9 of the cell 5b, the second electrode layer 4 and the photoelectric conversion layer 3 of the cell 5b are partially removed.

In Fig. 3(b), a symbol Pa₁ represents a position where the upper-stream side end portion 8a₁ of the first groove 8a is allowed to be formed on the upper-stream side cell 5a, and a symbol Pb₁ represents a position where the upper-stream side end portion 8b₁ of the second groove 8b is allowed to be formed on the upper-stream side cell 5a. A symbol Pa₂ represents a position where a lower-stream side end portion 8a₂ of the first groove 8a is allowed to be formed on the lower-stream side cell 5b, and a symbol Pb₂ represents a position where a lower-stream side end portion 8b₂ of the second groove 8b is allowed to be formed on the lower-stream side cell 5b.

On the other hand, parts of the cell 5a (the second electrode layer 4 and the photoelectric conversion layer 3) may be removed or not removed and thus is not removed in the embodiment 1, and the end portion 8b₁ of the second groove 8b arranged on the upper-stream side of the current direction E is positioned in the region of the element separating groove 9 adjacent to the cell 5a. That is to say, the end portion 8b₁ of the second groove 8b may be arranged in a range across a region of the cell 5 adjacent to the lower stream side of the cell 5a and a position tap into the cell 5a by a predetermined dimension.

When a fundamental wave of a YAG laser is used as a light beam to be used for forming the first groove 8a, not only the first electrode layer 2 but also the photoelectric conversion layer 3 and the second electrode layer 4 are removed. For this reason, the position of the end portion of the second groove 8b matches with at least the end portion of the first groove 8a, and is preferably a position surrounding the end portion of the first groove 8a.

Further, in the end portion 8a₂ of the first groove 8a arranged on the lower-stream side of the current direction E, a part of the cell 5b (the first electrode layer 4) may be removed or not removed and is not removed in the embodiment 1. The end portion 8a₂ is positioned near the element separating groove 9 of the cell 5 adjacent to the cell 5b. That is to say, the end portion 8a₂ of the first groove 8a may be arranged in the range across the region of the cell 5 adjacent to the upper-stream side of the cell 5b and the position tap into the cell 5b by a predetermined dimension.

When the first groove 8a and the second groove 8b are formed in such a manner, the first electrode layers 2 of the plurality of cells 5 in the direction of the arrow B adjacent to the cell 5a on the upper-stream side are insulated and separated. For this reason, one of the cells 5 leaks, the other cells 5 are not influenced. Further, the plurality of cells 5 adjacent to the cell 5b on the lower-stream side are connected by some parts of the first electrode layer 2, but since the second electrode layer 4 and the photoelectric conversion layer 3 are insulated and separated, even if one of these cells 5 leaks, the other cells 5 are not influenced.

In the present invention, the first electrode layer 2 of the plurality of cells 5 adjacent to the cell 5a on the upper-stream side are completely separated by the first groove 8a, and the second electrode layer 4 and the photoelectric conversion layer 3 (particularly, the second electrode layer 4) of the plurality of cells 5 adjacent to the cell 5b on the lower-stream side may be completely separated by the second groove 8b.

For this reason, the allowable range of forming the first groove 8a and the second groove 8b, namely, a range where both the ends of the first groove 8a and the second groove 8b can be formed is widened. As a result, the string separating groove 8 is formed by a simple method for controlling transfer of the light beam with a certain level of accuracy without accurately controlling the ON/OFF state of the light beam at the time of forming the string separating groove 8, so that the integrated thin-film solar battery where the plurality of strings S are connected in parallel can be obtained.

The transfer control of the light beam in the direction of the arrow A and the ON/ OFF control at the time of forming the first groove 8a and the second groove 8b are described in detail later.

For example, in the series-connecting direction A, a length of the cell 5a on the upper-stream side is 5 to 15 mm, a length of the cell 5b on the lower-stream side is 3 to 5 mm, a length of the other cells 5 is 5 to 15 mm, a width of the first and second power collecting electrodes 6 and 7 are 1 to 2 mm, and a width of the element separating groove 9 is 30 to 80 µm. In this case, the forming allowable range La of the upper-stream side end portion 8a₁ of the first groove 8a can be set to about 0 to 12 mm, and the forming allowable range Lb of the lower-stream side end portion 8b₂ of the second groove 8b can be set to about 0 to 2 mm.

The forming allowable position Pa₁ where the upper-stream side end portion 8a₁ of the first groove 8a is a position where the forming allowable position Pb₁ whose forming tolerance exceeds that of the forming allowable position Pa₁ can be enough unreachable with respect to the jointed portion of the first power collecting electrode 6. Further, the forming allowable position Pb₂ of the lower-stream-side end portion 8b₂ of the second groove 8b is enough unreachable with respect to the jointed portion of the second power collecting electrode 7.

In this string S, the cell 5b on the side of the second power collecting electrode 7 does not substantially contribute to power generation because the cell 5b is formed so that its width in the series-connecting direction A is narrow. For this reason, the second electrode 4 of the cell 5b is used as an extraction electrode of the first electrode 2 of the adjacent cell 5.

Further, the plurality of strings S are formed on an inner side with respect to outer peripheral end surfaces (end surfaces of four sides) of the transparent insulating substrate 1. That is to say, the outer peripheral region of the surface of the insulating substrate 1 is a nonconductive surface region 12 where the first electrode layer 2, the photoelectric conversion layer 3 and the second electrode layer 4 are not formed, and its width is set to a dimension range according to an output voltage from the solar battery.

### [Transparent Insulating Substrate and First Electrode Layer]

As the transparent insulating substrate 1, a glass substrate, a resin substrate made of polyimide or the like each having a heat-resistant in a subsequent film forming process and transparency.

The first electrode layer 2 is made of a transparent conductive film, and preferably made of a transparent conductive film including a material containing ZnO or SnO₂. The material containing SnO₂ may be SnO₂ itself, or may be a mixture of SnO₂ and another oxide (for example, ITO as a mixture of SnO₂ and In₂O₃).

### [Photoelectric Conversion Layer]

A material of each semiconductor layer configuring the photoelectric conversion layer 3 is not particularly limited, and each semiconductor layer includes, for example, a silicon semiconductor, a CIS (CuInSe₂) compound semiconductor, and a CIGS (Cu(In, Ga)Se₂) compound semiconductor.

A case where each semiconductor layer is made of the silicon semiconductor is described as an example below.

"The silicon semiconductor" means a semiconductor made of an amorphous silicon or a microcrystal silicon, or a semiconductor in which carbon, germanium or another impurity is added to an amorphous silicon or a microcrystal silicon (silicon carbide, silicon germanium or the like). Further, "the microcrystal silicon" means a silicon in a state of a mixed phase including a crystal silicon with a small grain size (about several dozens to several thousand Å) and an amorphous silicon. The microcrystal silicon is formed when a crystal silicon thin film is produced at a low temperature by using a nonequilibrium process such as a plasma CVD method.

The photoelectric conversion layer 3 is constituted so that a p-type semiconductor layer, an i-type semiconductor layer and an n-type semiconductor layer are laminated from the side of the first electrode 2. The i-type semiconductor layer may be omitted.

The p-type semiconductor layer is doped with p-type impurity atoms such as boron or aluminum, and the n-type semiconductor layer is doped with n-type impurity atoms such as phosphorus.

The i-type semiconductor layer may be a semiconductor layer that is completely undoped, and, may be a weak p-type or weak n-type semiconductor layer including a small amount of impurities that sufficiently has a photoelectric converting function.

In this specification, "the amorphous layer" and "the microcrystal layer" mean amorphous and microcrystal semiconductor layers, respectively.

Further, the photoelectric conversion layer 3 may be of a tandem type where a plurality of pin structures are laminated. The photoelectric conversion layer 3 may include, for example, an upper semiconductor layer where an a-Si:H p-layer, an a-Si:H i-layer and an a-SiH n-layer are laminated on the first electrode 2 in this order, and a lower semiconductor layer where a µc-Si:H p-layer, a µc-Si:H i-layer and a µc-Si:H n-layer are laminated on the upper semiconductor layer in this order.

Further, the pin structure may be the photoelectric conversion layer 3 having a three-layered structure including the upper semiconductor layer, a middle semiconductor layer and the lower semiconductor layer. For example, the three-layered structure may be such that an amorphous silicon (a-Si) is used for the upper and middle semiconductor layers, and a microcrystal silicon (µc-Si) is used for the lower semiconductor layer.

A combination of the material of the photoelectric conversion layer 3 and the laminated structure is not particularly limited.

In embodiments and examples of the present invention, a semiconductor layer positioned on a light incident side of the thin-film solar battery is the upper semiconductor layer, and a semiconductor layer positioned on a side opposite to the light incident side is the lower semiconductor layer. A straight line drawn in the photoelectric conversion layer 3 in Figs. 2(a) to (c) shows a boundary between the upper semiconductor layer and the lower semiconductor layer.

### [Second Electrode Layer]

A structure and a material of the second electrode layer 4 are not particularly limited, but in one example, the second electrode 4 has a laminated structure where a transparent conductive film and a metal film are laminated on the photoelectric conversion layer.

The transparent conductive film is made of ZnO, ITO, SiO₂ or the like. The metal film is made of metal such as silver or aluminum.

The second electrode layer 4 may be made of only a metal film of Ag or Al, but it is preferable that the transparent conductive film made of ZnO, ITO or SnO₂ is arranged on the side of the photoelectric conversion layer 3 because a reflection rate at which light unabsorbed by the photoelectric conversion layer 3 is reflected from the rear electrode layer 4 is improved, and the thin-film solar battery with high conversion efficiency can be obtained.

### [Another Structure]

As not shown, but in this solar battery, a rear surface sealing material is laminated on the transparent insulating substrate 1 via an adhesive layer so as to completely cover the string S and a nonconductive surface region 8.

As the adhesive layer, for example, a sealing resin sheet made of ethylene-vinyl acetate copolymer (EVA) can be used.

As the rear surface sealing material, for example, a laminated film where an aluminum film is sandwiched by a PET film can be used.

Small holes for leading front ends of extraction lines to be connected to the respective power collecting electrodes to the outside are formed on the adhesive layer and the rear surface sealing material in advance.

A terminal box having output lines and terminals to be electrically connected to extraction lines 13 is mounted onto the rear surface sealing material.

Further, a frame (made of, for example, aluminum) is attached to an outer peripheral portion of the solar battery sealed by the rear surface sealing material and the adhesive layer.

### <Method for Manufacturing the Integrated Thin-Film Solar Battery>

The integrated thin-film solar battery can be manufactured by a manufacturing method including a pre-division string forming step of forming a pre-division string where the plurality of thin-film photoelectric conversion elements are electrically connected in series to each other on the surface of the transparent insulating substrate 1, and a string dividing step of removing a predetermined portion of the pre-division string using a light beam to form the string separating groove 8 extending in the series-connecting direction so as to form the plurality of strings S.

The method for manufacturing the integrated thin-film solar battery is described below with reference to Figs. 1 to 4.

### [Pre-division String Forming Step]

The pre-division string forming step includes a depositing step of laminating the first electrode layer, the photoelectric conversion layer and the second electrode layer on the surface of the transparent insulating substrate 1 in this order so as to form a laminated film, and a step of removing the second electrode layer and the photoelectric conversion layer from the laminated film to form the plurality of element separating grooves 9 extending to the direction (the direction of the arrow B) perpendicular to the series-connecting direction so as to form the plurality of thin-film photoelectric conversion elements.

At the depositing step, a transparent conductive film having a thickness of 600 to 1000 nm is formed on an entire one surface of the transparent insulating substrate 1 by a CVD, sputtering or vapor deposition method and is partially removed by a light beam so that the plurality of parallel electrode separating lines 10 extending to the direction of the arrow B is formed. As a result, the first electrode layer 2 is formed into a predetermined pattern. At this time, a fundamental wave of the YAG laser (wavelength: 1064 nm) is emitted to the transparent insulating substrate 1 so that the transparent conductive film is divided into a strip shape of a predetermined width. As a result, the plurality of electrode separating lines 10 are formed at predetermined intervals.

Thereafter, the obtained substrate is ultrasonically cleaned by pure water, and a photoelectric conversion film is formed on the first electrode layer 2 so that the electrode separating lines 10 are completely filled up by p-CVD. For example, an a-Si:H p-layer, an a-Si:H i-layer (film thickness is about 150 nm to 300 nm) and an a-Si:H n-layer are laminated on the first electrode 2 in this order so that an upper semiconductor layer is formed. A µc-Si:H p-layer, a µc-Si:H i-layer (film thickness is about 1.5 µm to 3 µm) and a µc-Si:H n-layer are laminated on the upper semiconductor layer in this order so that a lower semiconductor layer is formed.

Thereafter, the photoelectric conversion film having a tandem structure is partially removed by the light beam and a contact line for forming the conductive section 4a is formed so that the photoelectric conversion layer 3 having a predetermined pattern is formed. At this time, a second harmonic of a YAG laser (wavelength: 532 nm) is emitted to the transparent insulating substrate 1, so that the photoelectric conversion film is separated into a strip shape with a predetermined width. A second harmonic of a YVO₄ laser (wavelength: 532 nm) may be used instead of the second harmonic of the YAG laser.

A conductive film is formed on the photoelectric conversion layer 3 by the CVD, sputtering or vapor deposition method so as to completely embed the contact lines, and the conductive film and the photoelectric conversion layer 3 are partially removed by a light beam so that the element separating groove 9 is formed and thus the second electrode layer 4 having a predetermined pattern is formed. As a result, the pre-division string where the plurality of cells 5 are electrically connected in series by the conductive sections 4a is formed on the transparent insulating substrate 1.

At this time, since the pre-division strings is not yet divided plurally, one cell extends long in the direction of the arrow B.

At this step, the conductive film has a two-layered structure including the transparent conductive film (ZnO, ITO, SnO₂ or the like) and the metal film (Ag, Al or the like). A film thickness of the transparent conductive film can be 10 to 100 nm, and a film thickness of the metal film can be 100 to 500 nm.

Further, in patterning of the second electrode layer 4, in order to avoid damage to the first electrode layer 2 due to a light beam, a second harmonic of an YAG laser or a second harmonic of the YVO₄ laser that has high permeability with respect to the first conductive layer 2 is emitted to the transparent insulating substrate 1 so that the conductive film is separated into a strip pattern with a predetermined width so that the element separating grooves 9 are formed. At this time, processing conditions are preferably selected so that the damage to the first electrode layer 2 is suppressed to minimum and generation of a burr on a processed silver electrode of the second electrode layer 4 is suppressed.

### [String Dividing Step]

At the string dividing step, the pre-division string is partially removed by a light beam so that the string separating grooves 8 are formed only on some parts of any thin-film photoelectric conversion elements extending in the direction B perpendicular to the series-connecting direction A.

Concretely, in the embodiment 1, the pre-division string is partially removed by the laser beam so that the string separating grooves 8 are formed only on some parts of the upper-stream side cell 5a (parallel-connection element on upper-stream side) 5a and the lower-stream side cell (parallel-connection element on lower-stream side) 5b. The plurality of parallel-connected strings S are formed with the cells 5a and 5b. At this time, the string separating groove 8 includes the first groove 8a formed by removing the first electrode layer 2 and the second groove 8b formed by removing the photoelectric conversion layer 3 and the second electrode layer 4 with a width wider than that of the first groove 8a.

This string dividing step includes a first stage of emitting a first groove forming light beam for enabling the first electrode layer 2, the photoelectric conversion layer 3 and the second electrode 4 to be removed to the transparent insulating substrate 1 while transferring the first groove forming light beam to the series-connecting direction A so as to form the first groove 8a, and a second stage of emitting a second groove forming light beam for enabling the photoelectric conversion layer 3 and the second electrode layer 4 to be removed to the transparent insulating substrate 1 while transferring the second groove forming light beam to the series-connecting direction A so as to form the second groove 8b.

In another manner, the string dividing step includes a first stage of emitting a second groove forming light beam for enabling the photoelectric conversion layer 3 and the second electrode layer 4 to be removed to the transparent insulating substrate 1 while transferring the second groove forming light beam to the series-connecting direction A so as to form the second groove 8b, and a second stage of emitting a first groove forming light beam for enabling the first electrode layer 2 to be removed to the transparent insulating substrate 1 while transferring the first groove forming light beam to the series-connecting direction A so as to form the first groove 8a.

That is to say, any one of the first groove 8a and the second groove 8b may be formed first. In this case, a fundamental wave of the YAG laser can be used as the first groove forming light beam, and its beam diameter can be set to about 10 to 1000 µm. Further, a second harmonic of the YAG laser or a second harmonic of the YVO₄ laser having high permeability with respect to the first conductive layer 2 can be used as the second groove forming light beam, and its beam diameter can be set to about 10 to 1000 µm.

### <Formation of the First Groove>

When the first groove 8a is formed, as shown in Fig. 3, the transfer of the light beam for forming the first groove is controlled so that the end portion 8a₁ of the first groove 8a to be formed on the upper-stream side of the current direction E is arranged on the upper-stream side with respect to the first electrode layer 2 of the cell 5 adjacent to the lower-stream side of the cell 5a on the upper-stream side. Further, the transfer of the light beam for forming the first groove is controlled so that the end portion 8a₂ on the lower stream side of the first groove 8a is arranged in a range across the region of the cell 5 adjacent to the upper-stream side of the cell 5b on the lower-stream side to the position Pa₂ tap into the cell 5b by a predetermined dimension.

In the embodiment 1, the end portion 8a₁ of the first groove 8a is arranged in the region of the element separating groove 9, and the end portion 8a2 of the first groove 8a is arranged on the upper-stream side slightly with respect to the element separating groove 9.

At this time, a transfer direction of the light beam for forming the first groove may be a direction from the upper-stream side to the lower-stream side or a direction from the lower-stream side to the upper-stream side. That is to say, when the first groove 8a is formed so that the end portion 8a₁ on the upper-stream side and the end portion 8a₂ on the lower-stream side of the first groove 8a are arranged in the above ranges, any one of the ON state and the OFF state of the light beam for forming the first groove can be selected for the upper-stream side or the lower stream side of the end portion of the first groove 8a.

For example, the beam emitting unit starts (ON) to emit the light beam for forming the first groove in the range La on the side of the cell 5a and is transferred to the cell 5b along the series-connecting direction A by a transfer mechanism while emitting the light beam. When the light beam is transferred to the position on the upper-stream side with respect to the position Pa₂ near the element separating groove 9 on the side of the cell 5b, the transfer mechanism is stopped. Soon after that or simultaneously with that, the emission of the light beam is stopped (OFF).

As a result, the first groove 8a is formed on the pre-division string. Such a formation of the first groove 8a is carried out in the direction of the arrow B with the predetermined intervals at the same number of times as the number of the string separating grooves 8 to be formed.

At this time, when the accuracy of the position control for the light beam using the transfer mechanism includes a certain level of an error, a start position and a stop position of the transfer of the light beam in the direction A are controlled so that the end portions 8a₁ and 8a₂ of the first groove 8a are formed in the above ranges in view of this error.

The transfer mechanism is not particularly limited, and a transfer mechanism that reciprocates a movable section of a linear guide for supporting the beam emitting unit movably in a horizontal direction using a driving source such as a ball screw, a belt pulley or a cylinder can be used.

The above-mentioned operation for forming the first groove 8a may be reversed. However, since the position of the end portion 8a₁ of the first groove 8a on the upper stream side is more important than the position of the end portion 8a₂ on the lower-stream side, it is preferable that the beam emitting unit is located on the position where the upper-stream side end portion 8a₁ is formed and then the emission of the light beam for forming the first groove is started (ON) to be transferred to the lower-stream side.

Further, at the time of forming the first groove 8a, instead of transferring the light beam, the position of the light beam may be fixed and the substrate may be transferred and stopped. In another manner, both the light beam and the substrate may be transferred and stopped.

### <Formation of the Second Groove>

When the second groove 8b is formed, as shown in Fig. 3, the transfer of the light beam for forming the second groove is controlled so that the end portion 8b₁ of the second groove 8b to be formed on the upper-stream side of the current direction E is arranged in a range between the region of the cell 5 adjacent to the lower-stream side of the cell 5a on the upper-stream side and the position Pb₁ tap into the cell 5a by a predetermined dimension. Further, the transfer of the light beam for forming the second groove is controlled so that the end portion 8b₂ of the second groove 8b on the lower-stream side is arranged on the lower-stream side with respect to the second electrode layer 4 of the cell 5 adjacent to the upper-stream side of the cll 5b on the lower-stream side.

In the embodiment 1, the end portion 8b₁ of the second groove 8b is arranged in the region of the element separating groove 9, and the end portion 8b₂ of the second groove 8b is arranged on the position near the element separating groove 9 of the cel 5b.

At this time, the transfer direction of the light beam for forming the second groove may be any one of the direction from the upper-stream side to the lower-stream side and the direction from the lower-stream side to the upper-stream side. That is to say, when the second groove 8b is formed so that the end portion 8b₁ on the upper-stream side and the end portion 8b₂ on the lower-stream side of the second groove 8b are arranged in the above ranges, any one of the ON state and the OFF state of the light beam for forming the second groove can be selected for the upper-stream side or the lower-stream side of the end portions of the second groove 8b.

For example, the beam emitting unit starts (ON) to emit the light beam for forming the second groove to the range Lb on the side of the cell 5b and is transferred to the cell 5a along the series-connecting direction A by the transfer mechanism while emitting the light beam. When the light beam transfers to the position near the element separating groove 9 on the side of the cell 5a (the lower-stream side with respect to the position Pa₁), the transfer mechanism is stopped. Soon after that or simultaneously with that, the emission of the light beam is stopped (OFF). As a result, the second groove 8b is formed on the pre-division string.

When a diameter of the light beam for forming the second groove is smaller than the width of the second groove 8b to be formed, the beam emitting unit is transferred to the series-connecting direction A at a plurality of times so that the second groove 8b with a desired width is formed.

Further, such a formation of the first groove 8b is carried out in the direction of the arrow B with the predetermined intervals at the same number of times as the number of the string separating grooves 8 to be formed.

At this time, the transfer mechanism that transfers the light beam for forming the second groove can be similar to the transfer mechanism that transfers the light beam for forming the first groove, or the one transfer mechanism may be shared.

Therefore, when the accuracy of the position control for the light beam using the transfer mechanism includes a certain level of an error, a start position and a stop position of the transfer of the light beam in the direction A are controlled so that the end portions 8b₁ and 8b₂ of the first groove 8b are formed in the above ranges in view of this error.

The above-mentioned operation for forming the second groove 8b may be reversed. However, since the position of the end portion 8b₂ of the second groove 8b on the lower stream side is more important than the position of the end portion 8b₁ on the upper-stream side, it is preferable that the beam emitting unit is located on the position where the lower-stream side end portion 8b₂ is formed and then the emission of the light beam for forming the second groove is started (ON) to be transferred to the lower-stream side.

Further, at the time of forming the second groove 8b, instead of transferring the light beam, the position of the light beam may be fixed and the substrate may be transferred and stopped. In another manner, both the light beam and the substrate may be transferred and stopped.

Conventionally, since the positions of both the ends of the string separating groove are controlled only by the control of the ON/OfF state of the light beam emission, a position of the string to which the light beam is emitted should be accurately understood, and thus the position of the light beam or the beam emitting unit should be detected accurately.

On the contrary, in the present invention, the positions of the both ends of the string separating groove 8 (the first groove 8a and the second groove 8b) are controlled not by the control of the ON/OfF state of the beam emission. As described above, the transfer of the light beam to the series-connecting direction A is controlled in view of the position accuracy error of the transfer mechanism, so that the positions of the both ends of the string separating groove are controlled.

Since the emission start position and stop position of the light beam may be within the above ranges, the position of the light beam or the beam emitting unit does not have to be accurately detected. Furthermore, since the transfer mechanism does not have to be particularly accurately structured so that the beam emitting unit is abruptly stopped, the transfer mechanism with a simple structure can be manufactured at low cost.

### [Other Steps]

After or before this string dividing step, the portions of the thin-film photoelectric conversion elements formed on the outer periphery on the surface of the transparent insulating substrate 1 (the first electrode layer 2, the photoelectric conversion layer 3 and the second electrode layer 4) are removed by the predetermined width across the outer peripheral end surface of the transparent insulating substrate 1 and the inner side using the fundamental wave of the YAG laser, for example, so that the nonconductive surface region 12 is formed on the entire periphery. As a result, plural lines of strings S surrounded by the nonconductive surface region 12 are formed.

The brazing filler metal (for example, silver paste) is applied onto the second electrode layer 4 of the cells 5a and 5b on both the ends of the series-connecting direction A, and the first and second power collecting electrodes 6 and 7 are press-bonded so as to be electrically connected. As a result, an electric current extraction section is formed.

### (Embodiment 2)

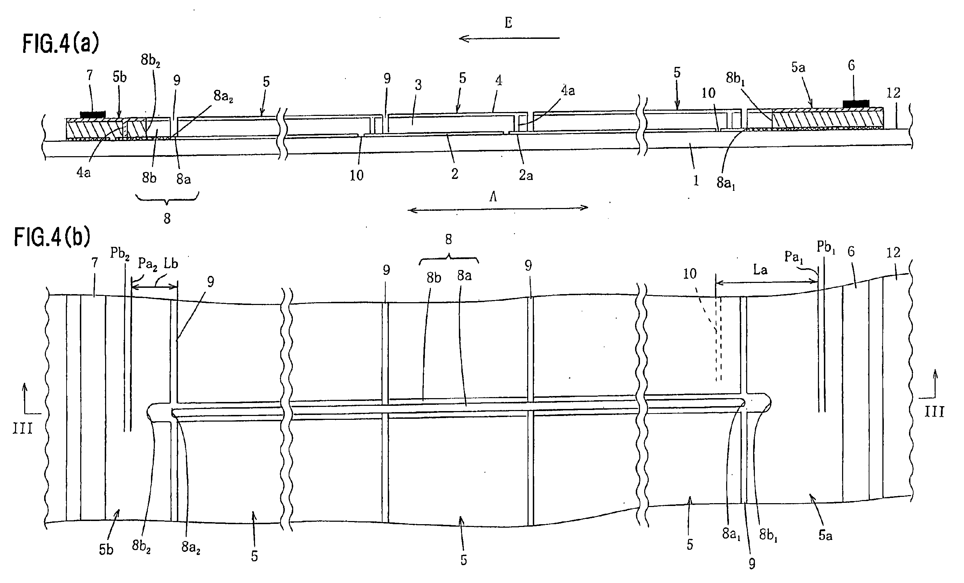

Fig. 4(a) is a partial cross-sectional view illustrating a vicinity of the string dividing groove of the integrated tin-film solar battery according to the embodiment 2, and Fig. 4(b) is a partial plan view illustrating the vicinity of the string separating groove of the integrated thin-film solar battery according to the embodiment 2.

Differences of the embodiment 2 with the embodiment 1 include a point such that the lower-stream side end portion 8a₂ of the first groove 8a of the string separating groove 8 is arranged in the region of the element separating groove 9 adjacent to the lower-stream side cell 5b, a point such that the upper-stream side end portion 8b₁ of the first groove 8b is arranged in the region of the upper-stream side cell 5a, and a point such that the entire first groove 8a is arranged in the inner region of the second groove 8b.

The other parts of the constitution in the embodiment 2 are similar to those in the embodiment 1.

As described in the embodiment 1, in the present invention, the first electrode layers 2 of the plurality of cells 5 adjacent to the upper-stream side cell 5a may be completely separated by the first groove 8a, and the second electrode layer 4 and the photoelectric conversion layer 3 (particularly the second electrode layer 4) of the plurality of cells 5 adjacent to the lower-stream side cell 5b may be completely separated by the second groove 8b at least. For this reason, the both ends of the first groove 8a and the second groove 8b may be arranged as shown in Figs. 4(a) and (b).

Also in this case, similarly to the embodiment 1, the string separating grooves 8 can be formed by controlling the transfer of the light beam by means of the simple transfer mechanism without accurately controlling ON/OFF state of the light beam for forming the string separating grooves 8.

Further, since the entire first groove 8a is arranged in the inner range of the second groove 8b, even when the first electrode layer 2 and the second electrode layer 4 are shorted by a conductive material that flies at the time of forming the both ends of the first groove 8a, the second groove 8b is formed later so that the shorted portion is removed.

On the contrary, even when the second groove 8b is first formed, the first groove 8a is formed in the range of the second groove 8b. For this reason, the conductive material that flies at the time of forming the first groove makes the short circuit between the first electrode layer 2 and the second electrode layer 4 difficult.

### (Embodiment 3)

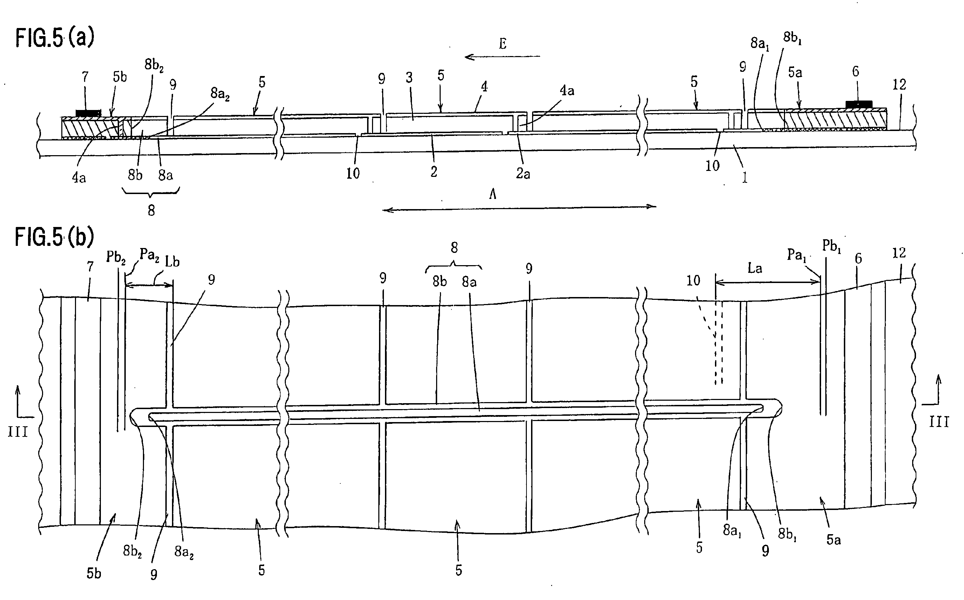

Fig. 5(a) is a partial cross-sectional view illustrating the vicinity of the string dividing groove of the integrated thin-film solar battery in the series-connecting direction according to an embodiment 3, and Fig. 5(b) is a partial plan view illustrating the vicinity of the string separating groove of the integrated thin-film solar battery according to the embodiment 3.

Differences of the embodiment 3 with the embodiment 1 include a point such that the upper-stream side end portion 8a₁ of the first grove 8a of the string separating groove 8 is arranged in the region of the upper-stream side cell 5a, a point such that the lower-stream side end portion 8a₂ of the first grove 8a is arranged in the region of the lower-stream side cell 5b, and a point such that the entire first groove 8a is arranged in the inner region of the second groove 8b.

The other parts of the constitution in the embodiment 3 are similar to those of the embodiment 1.

Also with this constitution, the first electrode layer 2 of the plurality of cells 5 adjacent to the upper-stream side cell 5a can be completely separated by the first groove 8a, and the second electrode layer 4 and the photoelectric conversion layer 3 (particularly, the second electrode layer 4) of the plurality of cells 5 adjacent to the lower-stream side cell 5b can be completely separated by the second groove 8b.

According to the embodiment 3, similarly to the embodiment 1, the simple transfer mechanism controls the transfer of the light beam so that the string separating groove 8 can be formed without accurately controlling the ON/OFF state of the light beam for forming the string separating groove 8. Further, similarly to the embodiment 2, the short circuit at the end portions of the first groove 8a and the second groove 8b can be prevented.

### (Embodiment 4)

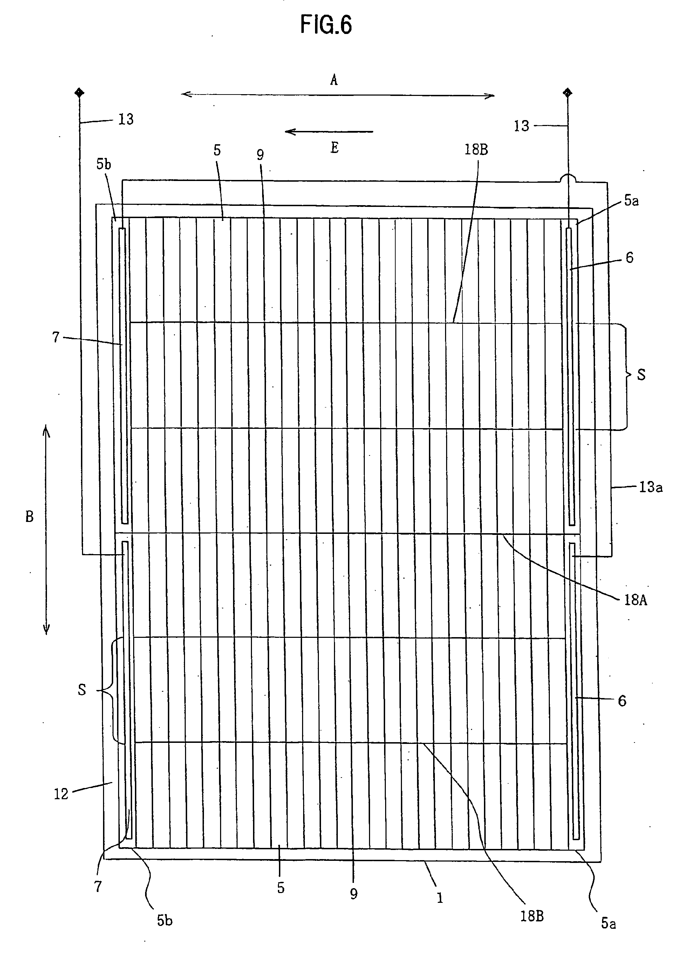

Fig. 6 is a plan view illustrating the integrated thin-film solar battery according to an embodiment 4 of the present invention. Components in Fig. 6 that are similar to the components in Figs. 1 to 3 are denoted by the same symbols.

In the solar battery according to the embodiment 4, the plurality of strings S are arranged on the one transparent insulating substrate 1 in the direction B perpendicular to the series-connecting direction A across the one or more string separating grooves extending to the series-connecting direction, and at least one string separating groove completely separates the plurality of strings S into groups. Further, the respective groups of the separated strings S are connected in parallel by the first power collecting electrode 16 and the second power collecting electrode 17, and the groups of the plurality of strings S connected in parallel are connected in series.

More specifically, in a case of the embodiment 4, the six strings S are formed on the one insulating substrate 1. One string separating groove 18A completely separates the first group including the adjacent three strings S and the second group including the other adjacent three strings S.

Further, a string separating groove 18B in each group does not completely separate the adjacent two strings S, and the cells 5a and 5b on the both sides of the series-connecting direction A in the three strings S in each group are integrated with each other. The first and second power collecting electrodes 6 and 7 are individually jointed onto the integrated cells 5a and 5b, respectively.

Therefore, the three strings S in each group are electrically connected in parallel, but the first group and the second group are not electrically connected in parallel.

In the solar battery having such a constitution, the first power collecting electrode 6 in the first group and the second power collecting electrode 7 in the second group are electrically connected in series by the extraction line 13a directly or via a connection to a connecting line provided to the terminal box. The residual first and second power collecting electrodes 6 and 7 are electrically connected to the output line of the terminal box via the extraction line 13.

According to the embodiment 4, electric currents generated in the first group and the second group flow to the current direction E, and the first group and the second group are connected in series. For this reason, the embodiment 4 is effective for a constitution where one solar battery can output a high-voltage current.

In the embodiment 4, the other parts of the constitution and the effects are similar to those in the embodiment 1.

### (Embodiment 5)

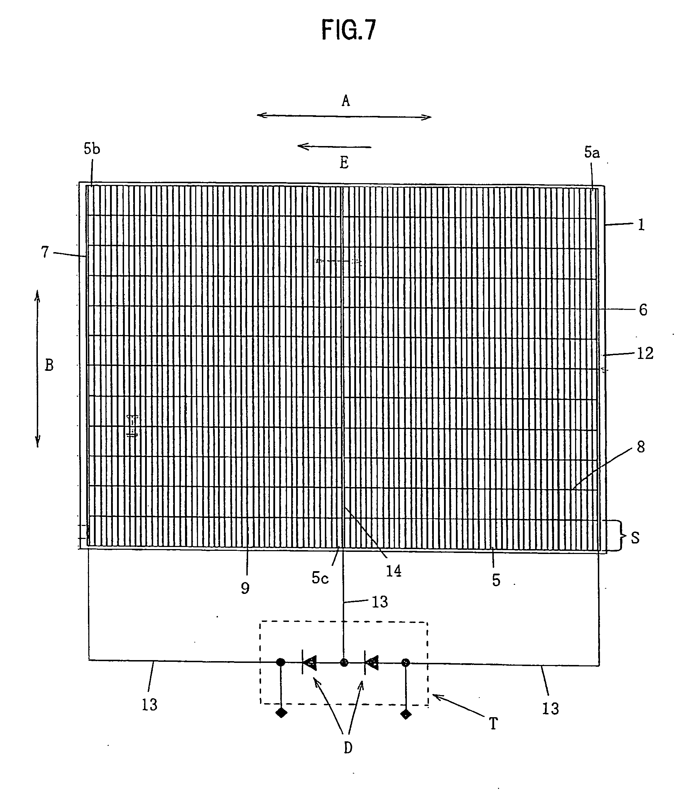

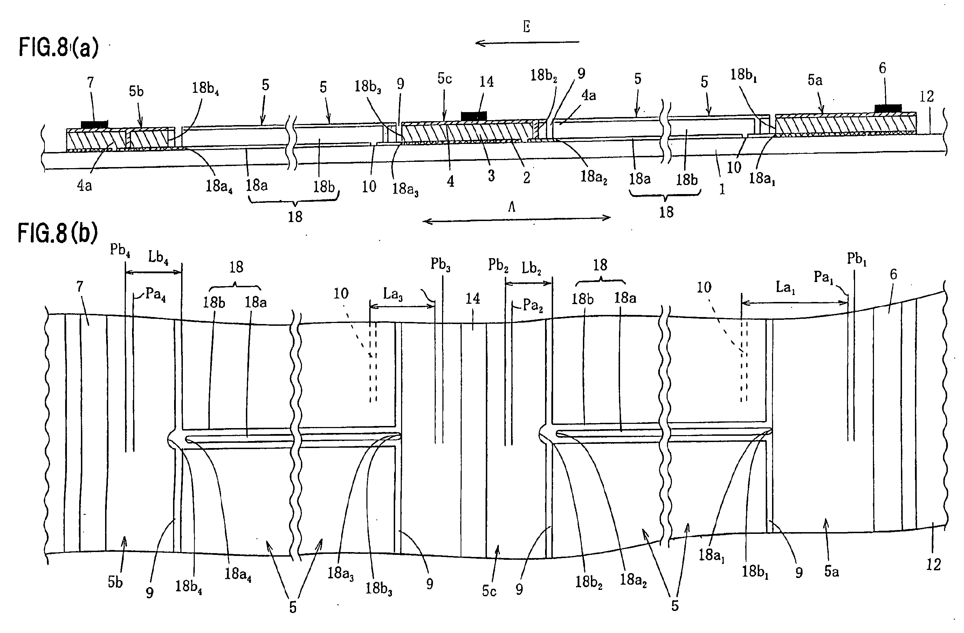

Fig. 7 is a plan view illustrating the integrated thin-film solar battery according to the embodiment 5 of the present invention. Fig. 8(a) is a partial cross sectional view illustrating the vicinity of the string dividing groove of the integrated thin-film solar battery in the series-connecting direction according to the embodiment 5, and Fig. 8(b) is a partial plan view illustrating the vicinity of the string separating groove of the integrated thin-film solar battery according to the embodiment 5. Components in Figs. 7 and 8 that are similar to the components in Figs. 1 to 3 are denoted by the same symbols.

Differences of the embodiment 5 with the embodiment 1 include the following two points.

The first point is that an intermediate power collecting electrode 14 is formed on the second electrode layer 4 of one or more cells 5c between the cells 5a and 5b on the both ends having the first power collecting electrode 6 and the second power collecting electrode 7.

The second point is that the cell 5c having the intermediate power collecting electrode 14 is an intermediate parallel-connection element whose one part is removed by a string separating groove 18 and whose residual parts are connected.

In the embodiment 5, the other parts of the constitution are similar to those in the embodiment 1.

In concretely description, in this solar battery, the plurality of strings S are arranged in parallel on the one transparent insulating substrate 1 across the string separating groove 18. The first and the second power collecting electrodes 6 and 7 are jointed onto the cells 5a and 5b of each string S on the upper-stream side and the lower-stream side in the current direction E, respectively, and the respective strings S are electrically connected in parallel.

Further, the cell 5c in a substantially middle position of the series-connecting direction A in each string S (hereinafter, the intermediate cell 5c) is not divided by each string separating groove 18 but extends to the direction of the arrow B. The one intermediate power collecting electrode 14 is jointed onto the intermediate cell 5c via a brazing filler metal.

Each string separating groove 18 includes a first groove 18a and a second groove 18b whose width is wider than that of the first groove 18a similarly to the embodiment 1.

In Fig. 8(b), Pa₁ represents a position where an upper-stream side end portion 18a₁ of the first groove 18a is allowed to be formed on the upper-stream side cell 5a, and Pb₁ represents a position where an upper-stream side end portion 18b₁ of the second groove 18b is allowed to be formed on the upper-stream side cell 5a. Pa₂ represents a position where a lower-stream side end portion 18a₂ of the first groove 18a is allowed to be formed on the intermediate cell 5c, and Pb₂ represents a position where a lower-stream side end portion 18b₂ of the second groove 18b is allowed to be formed on the intermediate cell 5c. Pa₃ represents a position where an upper-stream side end portion 18a₃ of the first groove 18a is allowed to be formed on the intermediate cell 5c, and Pb₃ represents a position where an upper-stream side end portion 18b₃ of the second groove 18b is allowed to be formed on the intermediate cell 5c. Pa₄ represents a position where a lower-stream side end portion 18a₄ of the first groove 18a is allowed to be formed on the lower-stream side cell 5b, and Pb₄ represents a position where a lower-stream side end portion 18b₄ of the second groove 18b is allowed to be formed on the lower-stream side cell 5b.

In a case of the embodiment 5, since the positions where the end portions of the string separating grooves 18 with respect to the upper-stream side cell 5a and the lower-stream side cell 5b are formed are similar to those in the embodiment 1, description thereof is omitted.

The positions where the end portions of the string separating grooves 18 with respect to the intermediate cell 5c are formed are determined according to the upper-stream side cell 5a and the lower-stream side cell 5b in the embodiment 1.

In the string separating groove 18 on the upper-stream side with respect to the intermediate cell 5c, the lower-stream side end portion 18a₂ of the first groove 18a is formed in a range between the region of the cell 5 adjacent to the upper-stream side of the intermediate cell 5c and the position Pa₂ in the intermediate cell 5c.

Further, in the string separating groove 18 on the upper-stream side with respect to the intermediate cell 5c, the lower-stream side end portion 18b₂ of the second groove 18b is formed in the range Lb₂ up to the position Pa₂ in the intermediate cell 5c on the lower-stream side with respect to the second electrode layer 4 of the cell 5 adjacent to the upper-stream side of the intermediate cell 5c.

Such positions where the lower-stream side end portions 18a₂ and 18b₂ of the first groove 18a and the second groove 18b with respect to the intermediate cell 5c are formed are similar to the positions where the lower-stream side end portions 8a₂ and 8a₂ of the first groove 8a and the second groove 8b with respect to the lower-stream side cell 5b in the embodiment 1 are formed (see Fig. 3(a)).

In the string separating groove 18 on the lower-stream side with respect to the intermediate cell 5c, the upper-stream side end portion 18a₃ of the first groove 18a is formed in a range La₃ up to the position Pa₃ on the intermediate cell 5c on the upper-stream side with respect to the first electrode layer 2 of the cell 5 adjacent to the lower-stream side of the intermediate cell 5c.

Further, in the string separating groove 18 on the lower-stream side with respect to the intermediate cell 5c, the upper-stream side end portion 18b₃ of the second groove 18b is formed in a region of the cell 5 adjacent to the lower-stream side of the intermediate cell 5c (substantially, the range between the position of the upper-stream side end portion 18a₃ of the first groove 18a and the position Pb₃ on the intermediate cell 5c).

Such positions where the upper-stream side end portions 18a₃ and 18b₃ of the first groove 18a and the second groove 18b with respect to the intermediate cell 5c are formed are similar to the positions where the upper-stream side end portions 8a₁ and 8b₁ of the first groove 8a and the second groove 8b with respect to the upper-stream side cell 5a in the embodiment 1 are formed (see Fig. 3(a)).

Therefore, the string separating groove 18 on the upper-stream side of the two string separating grooves 18 arranged in the series-connecting direction A completely separates the first groove layer 2 of the plurality of cells 5 adjacent to the upper-stream-side cell 5a in the first groove 18, and completely separates the second electrode layer 4 and the photoelectric conversion layer 3 of the plurality of cells 5 adjacent to the intermediate cell 5c in the second groove 8b.

Further, the string separating groove 18 on the lower-stream side completely separates the first electrode layer 2 of the plurality of cells 5 adjacent to the intermediate cell 5c in the first groove 18a, and completely separates the second electrode layer 4 and the photoelectric conversion layer 3 of the plurality of cells 5 adjacent to the lower-stream side cell 5b in the second groove 8b.

As a result, similarly to the embodiment 1, the simple transfer mechanism controls the transfer of the light beam so that the string separating grooves 18 can be formed without the accurate ON/OFF control of the light beam for forming the string separating grooves 18.

According to the embodiment 5, the two string separating grooves 18 are formed in the direction A according to the embodiment 1, and the similar step is executed in the direction B at plural times at predetermined intervals. As a result, as shown in Fig. 7, the solar battery where the plurality of strings S are connected in parallel can be manufactured by the first power collecting electrode 6, the intermediate power collecting electrode 14 and the second power collecting electrode 7.

Thereafter, a plurality of bypass diodes D provided into the terminal box T are electrically connected in parallel to the plurality of strings S connected in parallel via the extraction line 13, and are electrically connected in series to each other.

Such a connection can provide the integrated thin-film solar battery that while hot-spot resistance is being maintained, outputs a high voltage.

In the embodiment 5, the parts other than the above constitution and the above manufacturing method are similar to those in the embodiment 1.

### (Embodiment 6)

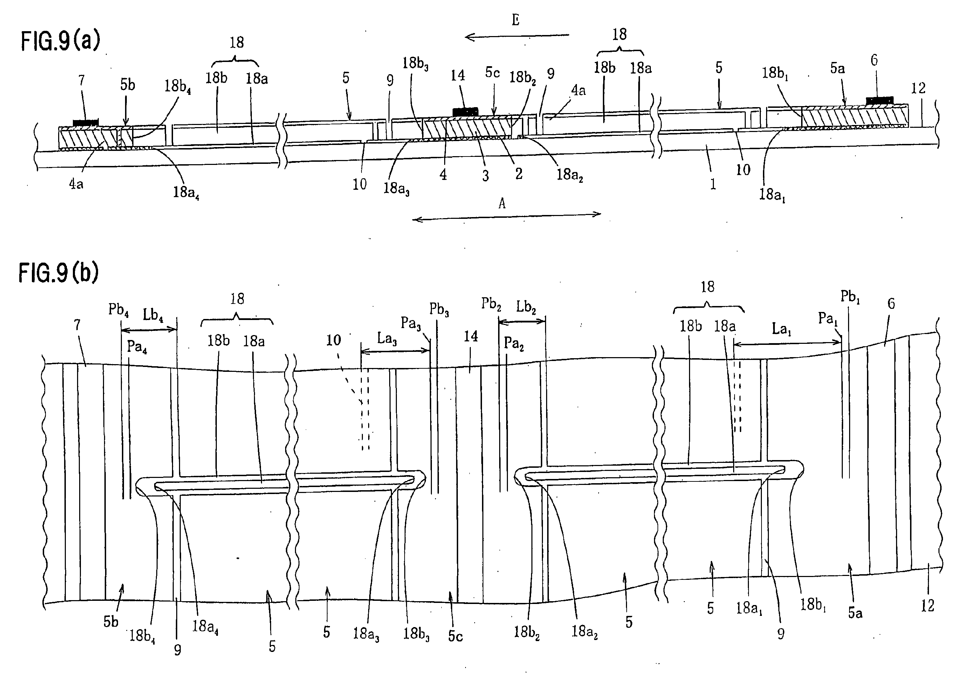

Fig. 9(a) is a partial cross-sectional view illustrating the vicinity of the string dividing groove of the integrated thin-film solar battery according to an embodiment 6, and Fig. 9(b) is a partial plan view illustrating the vicinity of the string separating groove of the integrated thin-film solar battery according to the embodiment 6.

Differences of the embodiment 6 with the embodiment 5 include the following three points.

The first point is that the lower-stream side end portions 18a₂ and 18a₄ of the first groove 18a of the two string separating grooves 18 in the direction of the arrow A are arranged in the regions of the intermediate cell 5c and the lower-stream side cell 5b.

The second point is that the upper-stream side end portions 18b₁ and 18b₃ of the second groove 18b of the respective string separating grooves 18 are arranged in the regions of the upper-stream side cell 5a and the intermediate cell 5c.

The third point is that the entire first groove 18a of each respective string separating groove 18 is arranged in the inner region of the second groove 18b.

The other parts of the constitution in the embodiment 6 are similar to those in the embodiment 5.

As a result, similar to the embodiment 1, the simple transfer mechanism controls the transfer of the light beam so that the string separating grooves 8 can be formed without the accurate ON/OFF control of the light beam for forming the string separating grooves 8. Further, since the entire first groove 18a is arranged in the inner region of the second groove 18b, the conductive material that flies at the time of forming the both ends of the first groove 8a can prevent the short circuit between the first electrode layer 2 and the second electrode layer 4.

### (Another Embodiment)

The number of the strings, the attachment positions and the number of the power collecting electrodes are not limited to the above embodiments. For example, the intermediate power collecting electrode is left, and the first and second power collecting electrodes on the both ends in the series-connecting direction may be connected to the first electrode layer (p-side electrode, n-side electrode).

Further, the intermediate power collecting electrode may be provided to a plurality of places in the series-connecting direction of the string.

Further, all the power collecting electrodes may be omitted.

Further, a number of string forming regions on one transparent insulating substrate is four, and a group of the strings is formed on each section, and a plurality of groups may be connected into a desired form.

### DESCRIPTION OF REFERENCE SYMBOLS

1: transparent insulating substrate
2, 2b: transparent first electrode layer
2a: extending section
3: photoelectric conversion layer
4: second electrode layer
4a: conductive section
5, 5a, 5b, 5c: thin-film photoelectric conversion element (cell)
6: first power collecting electrode
7: second power collecting electrode
8, 18: string separating groove
8a, 18a: first groove
8a₁, 8a₂, 18a₁, 18a2, 18a₃ and 18a₄: end portion of first groove
8b, 18b: second groove
8b₁, 8b₂, 18b₁, 18b₂, 18b₃ and 18b₄: end portion of second groove
9: element separating groove
10: electrode separating line
14: intermediate power collecting electrode
A: series-connecting direction
B: direction perpendicular to the series-connecting direction
E: current direction
D: bypass diode
La, La₁, La₃: range
Lb, Lb₂, Lb₄: range
S: string

## Claims

1. An integrated thin-film solar battery, comprising:
a plurality of strings (S) having a plurality of thin-film photoelectric conversion elements (5) formed on a transparent insulating substrate (1), the thin-film photoelectric conversion elements (5) being electrically connected in series to each other, wherein
the thin-film photoelectric conversion elements (5) have a first transparent electrode layer (2) laminated on the transparent insulating substrate (1), a photoelectric conversion layer (3) laminated on the first electrode layer (2) and a second electrode layer (4) laminated on the photoelectric conversion layer (3),
the plurality of strings (S) are arranged in parallel on the same transparent insulating substrate (1) in a direction perpendicular to the series-connecting direction across one or more string separating grooves (8) extending to the series-connecting direction,
the string separating groove (8, 18) includes a first groove (8a, 18a) formed by removing the first electrode layer (2), and a second groove (8b, 18b) formed by removing the photoelectric conversion layer (3) and the second electrode layer (4) with a width wider than that of the first groove (8a, 18a),
the thin-film photoelectric conversion elements (5) on any position in the series-connecting direction are parallel-connection elements (5a, 5b, 5c) in which a part of the photoelectric conversion layer (3) and the second electrode layer (4) is removed by the string separating groove and residual part of the photoelectric conversion layer (3) and the second electrode layer (4) is connected integrally so as to extend to the direction perpendicular to the series-connecting direction, and the parallel-connection elements (5a, 5b, 5c) electrically connect the plurality of strings in parallel.

2. The integrated thin-film solar battery according to claim 1, wherein
the string (S) has an element separating groove (9) that is formed by removing the second electrode layer (4) and the photoelectric conversion layer (3) between the two thin-film photoelectric conversion elements (5) adjacent in the series-connecting direction,
the first electrode layer (2) of one thin-film photoelectric conversion element has an extending section (2a) whose one end crosses the element separating groove (9) and extends to a region of adjacent another thin-film photoelectric conversion element (5) in the series-connecting direction, and is electrically insulated from the first electrode layer (2) of adjacent another thin-film photoelectric conversion element (5) in the series-connecting direction by an electrode separating line (10),
one end of the second electrode layer (4) of one thin-film photoelectric conversion element (5) is electrically connected to the extending section (2a) of the first electrode layer (2) of another thin-film photoelectric conversion element (5) adjacent in the series-connecting direction via the conductive section (4a) passing through the photoelectric conversion layer (3),
an end portion (8a1, 18a1, 18a3) of the first groove (8a, 18a) on an upper-stream side of a direction of an electric current flowing in the strings is arranged on an upper-stream side with respect to the first electrode layer (2) of the thin-film photoelectric conversion element adjacent to the lower-stream side of the parallel-connection element (5a) on upper-stream side adjacent to this end portion, and
an end portion (8b2, 18b2, 18b4) of the second groove (8b. 18b) on a lower-stream side of the current direction is arranged on a lower-stream side with respect to the second electrode layer (4) of the thin-film photoelectric conversion element adjacent to the upper-stream side of the parallel-connection element (5b, 5c) on lower-stream side adjacent to this end portion.

3. The integrated thin-film solar battery according to claim 2, wherein
an end portion (8b1, 18b1, 18b3) of the second groove (8b, 18b) on an upper-stream side of the current direction is arranged in a range between a region of the thin-film photoelectric conversion element (5) adjacent to the lower-stream side of the parallel-connection element (5a, 5c) on upper-stream side adjacent to this end portion and a position tap into the parallel-connection element (5a, 5c) on upper-stream side by a predetermined dimension, and
an end portion (8a2, 18a2, 18a4) of the first groove (8a, 18a) on a lower-stream side of the current direction is arranged in a range between a region of the thin-film photoelectric conversion element adjacent to the upper-stream side of the parallel-connection element (5b, 5c) on lower-stream side adjacent to this end portion and a position tap into the parallel-connection element (5b, 5c) on lower-stream side by a predetermined dimension.

4. The integrated thin-film solar battery according to claim 3, wherein
the end portion (8b1, 18b1, 18b3) of the second groove (8b, 18b) on the upper-stream side of the current direction is arranged in a region of the element separating groove (9) adjacent to the lower-stream side of the parallel-connection element (5a, 5c) on upper-stream side adjacent to this end portion or a region of the parallel-connection element (5a, 5c) on upper-stream side, and
the end portion (8a2, 18a2, 18a4) of the first groove (8a, 18a) on the lower-stream side of the current direction is arranged in a region of the element separating groove (9) adjacent to the upper-stream side of the parallel-connection element (5b, 5c) on lower-stream side adjacent to this end portion or a region of the parallel-connection element (5b, 5c) on lower-stream side.

5. The integrated thin-film solar battery according to claim 4, wherein the entire first groove (8a, 18a) is arranged in an inner region of the second groove (8b, 18b).

6. The integrated thin-film solar battery according to claim 1, wherein a power collecting electrode (6, 7) is further electrically jointed onto the second electrode layer (4) of the parallel-connection element (5a, 5b).

7. The integrated thin-film solar battery according to claim 6, wherein the power collecting electrode includes a first power collecting electrode (6) and a second power collecting electrode (7), and the first power collecting electrode (6) and the second power collecting electrode (7) are arranged on the second electrode layer (4) of the parallel-connection elements (5a, 5b) at the both ends of the series-connecting direction in the strings.

8. The integrated thin-film solar battery according to claim 7, wherein the power collecting electrode further has an intermediate power collecting electrode (14), and the intermediate power collecting electrode (14) is arranged on the second electrode layer (4) of the one or more parallel-connection elements (5c) between the parallel-connection elements (5a, 5b) on the both ends of the series-connecting direction in the strings.

9. The integrated thin-film solar battery according to claim 1, wherein a width of the first groove (8a, 18a) is 10 to 1000 µm, and a width of the second groove (8b, 18b) is 20 to 1500 µm.

10. The integrated thin-film solar battery according to claim 7, wherein
a plurality of groups including the plurality of strings are completely insulated and separated by at least one string separating groove (18b),
the plurality of strings in each group are electrically connected in parallel by the first power collecting electrode (6) and the second power collecting electrode (7), and
the plurality of groups are electrically connected in series.

11. The integrated thin-film solar battery according to claim 8,
wherein the bypass diodes are electrically connected in parallel to the plurality of strings electrically connected in parallel, and the plurality of bypass diodes are electrically connected in series.

12. A method for manufacturing an integrated thin-film solar battery, comprising:
a pre-division string forming step of forming a pre-division string on a surface of a transparent insulating substrate (1), the pre-division string having a plurality of thin-film photoelectric conversion elements (5) electrically connected to each other in series; and
a string dividing step of removing a predetermined portion of the pre-division string using a light beam and forming a string separating groove (8, 18) extending to a series-connecting direction so as to form a plurality of strings, wherein
the pre-division string forming step includes a depositing step of laminating a first electrode layer (2), a photoelectric conversion layer (3) and a second electrode layer (4) on the surface of the transparent insulating substrate (1) in this order so as to form a laminated film, and a step of removing the second electrode layer (4) and the photoelectric conversion layer (3) from the laminated film to form a plurality of element separating grooves (9) extending to a direction perpendicular to the series-connecting direction so as to form the plurality of thin-film photoelectric conversion elements (5),
the string separating groove (8, 18) includes a first groove (8a, 18a) formed by removing the first electrode layer (2) and a second groove (8b, 18b) formed by removing the photoelectric conversion layer (3) and the second electrode layer (4) with a width wider than that of the first groove (8a, 18a), and
at the string dividing step, the pre-division string is partially removed by a light beam so that the string separating groove (8, 18) is formed only on a part of the photoelectric conversion layer (3) and the second electrode layer (4) of any thin-film photoelectric conversion elements (5) extending to the direction perpendicular to the series-connecting direction, thereby forming the plurality of strings arranged in parallel in the direction perpendicular to the series-connecting direction and parallel-connection elements (5a, 5b, 5c) for electrically connecting the plurality of strings in parallel.

13. The method for manufacturing an integrated thin-film solar battery according to claim 12, wherein
the string dividing step includes a first stage of emitting a first groove forming light beam for enabling the first electrode layer (2), the photoelectric conversion layer (3) and the second electrode layer (4) to be removed to the transparent insulating substrate (1) while transferring the first groove forming light beam to the series-connecting direction so as to form the first groove (8a, 18a), and a second stage of emitting a second groove forming light beam for enabling the photoelectric conversion layer (3) and the second electrode layer (4) to be removed to the transparent insulating substrate (1) while transferring the second groove forming light beam to the series-connecting direction so as to form the second groove (8b, 18b),
at the first stage, transfer of the first groove forming light beam is controlled so that an end portion (8a1, 18a1, 18a3) of the first groove (8a, 18a) to be formed on an upper-stream side of a current direction where an electric current flows in the strings is arranged on an upper-stream side with respect to the first electrode layer (2) of the thin-film photoelectric conversion element (5) adjacent to a lower-stream side of the parallel-connection element (5a, 5c) on upper-stream side adjacent to this end portion, and
at the second stage, transfer of the second groove forming light beam is controlled so that an end portion (8b2, 18b2, 18b4) of the second groove (8b, 18b) to be formed on a lower-stream side of the current direction is arranged on a lower-stream side with respect to the second electrode (4) of the thin-film photoelectric conversion element (5) adjacent to the upper-stream side of the parallel-connection element (5b, 5c) on lower-stream side adjacent to this end portion.

14. The method for manufacturing an integrated thin-film solar battery according to claim 12, wherein
the string dividing step includes a first stage of emitting a second groove forming light beam for enabling the photoelectric conversion layer and the second electrode layer to be removed to the transparent insulating substrate while transferring the second groove forming light beam to the series-connecting direction so as to form the second groove, and a second stage of emitting a first groove forming light beam for enabling the first electrode layer to be removed to the transparent insulating substrate while transferring the first groove forming light beam to the series-connecting direction so as to form the first groove,
at the first stage, transfer of the second groove forming light beam is controlled so that an end portion (8b2, 18b2, 18b4) of the second groove (8b, 18b) to be formed on a lower-stream side of a current direction where an electric current flows in the strings is arranged on a lower-stream side with respect to the second electrode (4) of the thin-film photoelectric conversion element adjacent to an upper-stream side of the parallel-connection element (5b, 5c) on lower-stream side adjacent to this end portion, and
at the second stage, transfer of the first groove forming light beam is controlled so that an end portion (8a1, 18a1, 18a3) of the first groove (8a, 18a) to be formed on an upper-stream side of the current direction is arranged on an upper-stream side with respect to the first electrode (2) of the thin-film photoelectric conversion element adjacent to the lower-stream side of the parallel-connection element (5b, 5c) on upper-stream side adjacent to this end portion.

15. The method for manufacturing an integrated thin-film solar battery according to claim 13 or 14, wherein
the transfer of the second groove forming light beam is controlled so that the end portion (8b1, 18b1, 18b3) of the second groove (8b, 18b) to be formed on the upper-stream side of the current direction is arranged in a range between a region of the thin-film photoelectric conversion element (5) adjacent to the lower-stream side of the parallel-connection element (5a, 5c) on upper-stream side adjacent to this end portion and a position tap into the parallel-connection element (5a, 5c) on upper-stream-side by a predetermined dimension, and
the transfer of the first groove forming light beam is controlled so that the end portion (8a2, 18a2, 18a4) of the first groove (8a) to be formed on the lower-stream side of the current direction is arranged in a range between a region of the thin-film photoelectric conversion element (5) adjacent to the upper-stream side of the parallel-connection element (5b, 5c) on lower-stream side adjacent to this end portion and a position tap into the parallel-connection element (5b, 5c) on lower-stream-side by a predetermined dimension.

16. The method for manufacturing an integrated thin-film solar battery according to claim 15, wherein
the transfer of the second groove forming light beam is controlled so that the end portion (8b1, 18b1, 18b3) of the second groove (8b, 18b) to be formed on the upper-stream side of the current direction reaches a region of the element separating groove (9) adjacent to the lower-stream side of the parallel-connection element on upper-stream side adjacent to this end portion or a region of the parallel-connection element on upper-stream-side, and
the transfer of the first groove forming light beam is controlled so that the end portion (8a2, 18a2, 18a4) of the first groove (8a, 18a) to be formed on the lower-stream side of the current direction reaches a region of the element separating groove (9) adjacent to the upper-stream side of the parallel-connection element (5a, 5c) on lower-stream side adjacent to this end portion or a region of the parallel-connection element (5a, 5c) on lower-stream-side.

17. The method for manufacturing an integrated thin-film solar battery according to claim 13 or 14, wherein at the string dividing step, the transfer of the first groove forming light beam and the second groove forming light beam is controlled so that the entire first groove (8a) is arranged in an inner region of the second groove (8b).

18. The method for manufacturing an integrated thin-film solar battery according to claim 12, wherein a diameter of the first groove forming light beam is 10 to 1000 µm, and a diameter of the second groove forming light beam is 10 to 1000 µm.

19. The method for manufacturing an integrated thin-film solar battery according to claim 12, further comprising a step of electrically jointing the power collecting electrode (6) onto the second electrode layer (4) of the parallel-connection element (5a, 5b, 5c).

## Patentansprüche

1. Integrierte Dünnschichtsolarbatterie,
mit:
einer Mehrzahl von Abfolgen (S) mit einer Mehrzahl von fotoelektrischen Dünnschichtwandelelementen (5), die auf einem transparenten isolierenden Substrat (1) ausgebildet sind, wobei die fotoelektrischen Dünnschichtwandelelemente (5) elektrisch miteinander in Reihe verbunden sind,
wobei
die fotoelektrischen Dünnschichtwandelelemente (5) eine erste transparente Elektrodenschicht (2), welche auf dem transparenten isolierenden Substrat (1) geschichtet ist, eine fotoelektrische Wandelschicht (3), die auf der ersten Elektrodenschicht (2) geschichtet ist, und eine zweite Elektrodenschicht (4), die auf der fotoelektrischen Wandelschicht (3) geschichtet ist, aufweist,
die Mehrzahl von Abfolgen (S) parallel auf demselben transparenten isolierenden Substrat (1) in einer Richtung senkrecht zur Reihenverbindungsrichtung quer zu einer oder zu mehreren Abfolgentrennungsausnehmungen (8) angeordnet ist, welche sich zur Reihenverbindungsrichtung erstrecken,
die Abfolgentrennungsausnehmung (8, 18) eine erste Ausnehmung (8a, 18a), welche ausgebildet ist durch Entfernen der ersten Elektrodenschicht (2), sowie eine zweite Ausnehmung (8b, 18b) aufweist, welche ausgebildet ist durch Entfernen der fotoelektrischen Wandelschicht (3) und der zweiten Elektrodenschicht (4), mit einer Breite, welche größer ist als diejenige der ersten Ausnehmung (8a, 18a),
die fotoelektrischen Dünnschichtwandelelemente (5) an irgendeiner Position in der Reihenverbindungsrichtung Parallelverbindungselemente (5a, 5b, 5c) sind, bei welchen ein Teil der fotoelektrischen Wandelschicht (3) und der zweiten Elektrodenschicht (4) mittels der Abfolgentrennungsausnehmung entfernt ist und ein Restteil der fotoelektrischen Wandelschicht (3) und der zweiten Elektrodenschicht (4) einteilig verbunden sind, um sich zu der Richtung senkrecht zur Reihenverbindungsrichtung zu erstrecken und damit die Parallelverbindungselemente (5a, 5b, 5c) die Mehrzahl von Abfolgen parallel verbinden.

2. Integrierte Dünnschichtsolarbatterie nach Anspruch 1,
wobei
die Abfolge (S) eine Elementtrennungsausnehmung (9) aufweist, welche durch Entfernen der zweiten Elektrodenschicht (4) und der fotoelektrischen Wandelschicht (3) zwischen den fotoelektrischen Dünnschichtwandelelementen (5), die in der Reihenverbindungsrichtung benachbart sind, ausgebildet ist,
die erste Elektrodenschicht (2) eines fotoelektrischen Dünnschichtwandelelements einen Erstreckungsbereich (2a) aufweist, dessen eines Ende die Elementtrennungsausnehmung (9) überquert und der sich zu einem Bereich eines benachbarten anderen fotoelektrischen Dünnschichtwandelelements (5) in der Reihenverbindungsrichtung erstreckt, und von der ersten Elektrodenschicht (2) eines benachbarten anderen fotoelektrischen Dünnschichtwandelelements (5) in der Reihenverbindungsrichtung mittels einer Elektrodentrennungsleitung (10) elektrisch isoliert ist,
ein Ende der zweiten Elektrodenschicht (4) eines fotoelektrischen Dünnschichtwandelelements (5) elektrisch verbunden ist mit dem Erstreckungsbereich (2a) der ersten Elektrodenschicht (2) eines anderen fotoelektrischen Dünnschichtwandelelements (5) benachbart in der Reihenverbindungsrichtung mittels des leitfähigen Bereichs (4a), der durch die fotoelektrische Wandelschicht (3) passiert,
ein Endbereich (8a1, 18a1, 18a3) der ersten Ausnehmung (8a, 18a) auf einer vorgeschalteten Seite einer Richtung eines in den Abfolgen fließenden elektrischen Stroms auf einer vorgeschalteten Seite in Bezug auf die erste Elektrodenschicht (2) des fotoelektrischen Dünnschichtwandelelements benachbart zur nachgeschalteten Seite des Parallelverbindungselements (5a) auf der vorgeschalteten Seite benachbart zu diesem Endbereich angeordnet ist und
ein Endbereich (8b2, 18b2, 18b4) der zweiten Ausnehmung (8b, 18b) auf einer nachgeschalteten Seite der Stromrichtung auf einer nachgeschalteten Seite in Bezug auf die zweite Elektrodenschicht (4) des fotoelektrischen Dünnschichtwandelelements benachbart zur vorgeschalteten Seite des Parallelverbindungselements (5b, 5c) auf der nachgeschalteten Seite benachbart zu diesem Endbereich angeordnet ist.

3. Integrierte Dünnschichtsolarbatterie nach Anspruch 2,
wobei
ein Endbereich (8b1, 18b1, 18b3) der zweiten Ausnehmung (8b, 18b) an einer vorgeschalteten Seite der Stromrichtung in einem Bereich zwischen einem Gebiet des fotoelektrischen Dünnschichtwandelelements (5) benachbart zur nachgeschalteten Seite des Parallelverbindungselements (5a, 5c) auf der vorgeschalteten Seite benachbart zu diesem Endbereich und einem Positionsabzweig in das Parallelverbindungselement (5b, 5c) auf der nachgeschalteten Seite um ein bestimmtes Maß angeordnet ist und
ein Endbereich (8a2, 18a2, 18a4) der ersten Ausnehmung (8a, 18a) an einer nachgeschalteten Seite der Stromrichtung in einem Bereich zwischen einem Gebiet des fotoelektrischen Dünnschichtwandelelements benachbart zur vorgeschalteten Seite des Parallelverbindungselements (5b, 5c) auf der nachgeschalteten Seite benachbart zu diesem Endbereich und einem Positionsabzweig in das Parallelverbindungselement (5b, 5c) auf der nachgeschalteten Seite um ein bestimmtes Maß angeordnet ist.

4. Integrierte Dünnschichtsolarbatterie nach Anspruch 3,
wobei
der Endbereich (8b1, 18b1, 18b3) der zweiten Ausnehmung (8b, 18b) auf der vorgeschalteten Seite der Stromrichtung in einem Gebiet der Elementtrennungsausnehmung (9) benachbart zur nachgeschalteten Seite des Parallelverbindungselements (5a, 5c) auf der vorgeschalteten Seite benachbart zu diesem Endbereich oder in einem Gebiet des Parallelverbindungselements (5a, 5c) auf der vorgeschalteten Seite angeordnet ist und
der Endbereich (8a2, 18a2, 18a4) der ersten Ausnehmung (8a, 18a) auf der nachgeschalteten Seite der Stromrichtung in einem Gebiet der Elementtrennungsausnehmung (9) benachbart zur vorgeschalteten Seite des Parallelverbindungselements (5b, 5c) auf der nachgeschalteten Seite benachbart zu diesem Endbereich oder in einem Gebiet des Parallelverbindungselements (5b, 5c) auf der nachgeschalteten Seite angeordnet ist.

5. Integrierte Dünnschichtsolarbatterie nach Anspruch 4,
wobei die gesamte erste Ausnehmung (8a, 18a) in einem inneren Gebiet der zweiten Ausnehmung (8b, 18b) angeordnet ist.

6. Integrierte Dünnschichtsolarbatterie nach Anspruch 1,
wobei des Weiteren eine Stromsammelelektrode (6, 7) elektrisch auf der zweiten Elektrodenschicht (4) des Parallelverbindungselements (5a, 5b) verbunden ist.

7. Integrierte Dünnschichtsolarbatterie nach Anspruch 6,
wobei die Stromsammelelektrode eine erste Stromsammelelektrode (6) und eine zweite Stromsammelelektrode (7) aufweist und
wobei die erste Stromsammelelektrode (6) und die zweite Stromsammelelektrode (7) auf der zweiten Elektrodenschicht (4) der Parallelverbindungselemente (5a, 5b) an beiden Enden der Reihenverbindungsrichtung in den Abfolgen angeordnet sind.

8. Integrierte Dünnschichtsolarbatterie nach Anspruch 7,
wobei die Stromsammelelektrode des Weiteren eine Stromsammelzwischenelektrode (14) aufweist und
wobei die Stromsammelzwischenelektrode (14) auf der zweiten Elektrodenschicht (4) der einen oder der mehreren Parallelverbindungselemente (5c) zwischen den Parallelverbindungselementen (5a, 5b) an beiden Enden der Reihenverbindungsrichtung in den Abfolgen angeordnet ist.

9. Integrierte Dünnschichtsolarbatterie nach Anspruch 1,
wobei eine Breite der ersten Ausnehmung (8a, 18a) 10 bis 1000 µm beträgt und
wobei eine Breite der zweiten Ausnehmung (8b, 18b) 20 bis 1500 µm beträgt.

10. Integrierte Dünnschichtsolarbatterie nach Anspruch 7,
wobei eine Mehrzahl von Gruppen mit der Mehrzahl von Abfolgen vollständig isoliert und separiert ist durch mindestens eine Abfolgentrennungsausnehmung (18b),
wobei die Mehrzahl von Abfolgen in jeder Gruppe elektrisch parallel verbunden ist mittels der ersten Stromsammelelektrode (6) und der zweiten Stromsammelelektrode (7) und
wobei die Mehrzahl von Gruppen elektrisch in Reihe verbunden ist.

11. Integrierte Dünnschichtsolarbatterie nach Anspruch 8,
wobei die Bypassdioden mit der Mehrzahl von Abfolgen elektrisch parallel verbunden sind, welche elektrisch parallel verbunden sind, und
wobei die Mehrzahl von Bypassdioden elektrisch in Reihe verbunden sind.

12. Verfahren zum Herstellen einer integrierten Dünnschichtsolarbatterie, mit:
einem Vorunterteilungsabfolgenausbildungsschritt zum Ausbilden einer Vorunterteilungsabfolge auf einer Oberfläche eines transparenten isolierenden Substrats (1), wobei die Vorunterteilungsabfolge eine Mehrzahl von fotoelektrischen Dünnschichtwandlungselementen (5) aufweist, die elektrisch miteinander in Reihe verbunden sind, und
einem Abfolgenunterteilungsschritt des Entfernens eines bestimmten Bereichs der Vorunterteilungsabfolge unter Verwendung eines Lichtstrahls und des Ausbildens einer Abfolgenunterteilungsausnehmung (8, 18), die sich zur Reihenverbindungsrichtung erstreckt, um eine Mehrzahl von Abfolgen zu bilden,
wobei
der Vorunterteilungsabfolgenausbildungsschritt einen Abscheidungsschritt des Schichtens einer ersten Elektrodenschicht (2), einer fotoelektrischen Wandlungsschicht (3) und einer zweiten Elektrodenschicht (4) auf der Oberfläche des transparenten isolierenden Substrats (1) in dieser Reihenfolge, um eine laminierte Schicht zu bilden, sowie einen Schritt des Entfernens der zweiten Elektrodenschicht (4) und der fotoelektrischen Wandelschicht (3) von der laminierten Schicht aufweist, um eine Mehrzahl von Elementtrennungsausnehmungen (9) zu bilden, die sich zu einer Richtung senkrecht zur Reihenverbindungsrichtung erstrecken, um die Mehrzahl von fotoelektrischen Dünnschichtwandelelementen (5) zu bilden,
die Abfolgentrennungsausnehmung (8, 18) eine erste Ausnehmung (8a, 18a), welche durch Entfernen der ersten Elektrodenschicht (2) gebildet wird, und eine zweite Ausnehmung (8b, 18b) aufweist, welche durch Entfernen der fotoelektrischen Wandelschicht (3) und der zweiten Elektrodenschicht (4) gebildet wird, mit einer Breite, die größer ist als diejenige der ersten Ausnehmung (8a, 18a) und
beim Abfolgenunterteilungsschritt die Vorunterteilungsabfolge teilweise durch einen Lichtstrahl derart entfernt wird, dass die Abfolgentrennungsausnehmung (8, 18) nur auf einem Teil der fotoelektrischen Wandelschicht (3) und der zweiten Elektrodenschicht (4) irgendeines fotoelektrischen Dünnschichtwandelelements (5) ausgebildet wird, welches sich zur Richtung senkrecht zur Reihenverbindungsrichtung erstreckt, um dadurch die Mehrzahl von Abfolgen, welche sich parallel in der Richtung senkrecht zur Reihenverbindungsrichtung erstrecken, sowie Parallelverbindungselemente (5a, 5b, 5c) zum elektrischen Verbinden der Mehrzahl von Abfolgen in paralleler Art und Weise zu bilden.

13. Verfahren zum Herstellen einer integrierten Dünnschichtsolarbatterie nach Anspruch 12,
wobei der Abfolgenunterteilungsschritt eine erste Stufe des Aussendens eines Lichtstrahls zum Ausbilden einer ersten Ausnehmung zum Ermöglichen, dass die erste Elektrodenschicht (2), die fotoelektrische Wandelschicht (3) und die zweite Elektrodenschicht (4) von der transparenten isolierenden Schicht (1) entfernt werden, während der Lichtstrahl zum Ausbilden der ersten Ausnehmung zur Reihenverbindungsrichtung übertragen wird, um die erste Ausnehmung (8a, 18a) auszubilden, sowie eine zweite Stufe aufweist des Aussendens eines Lichtstrahls zum Ausbilden einer zweiten Ausnehmung zum Ermöglichen, dass die fotoelektrische Wandelschicht (3) und die zweite Elektrodenschicht (4) vom transparenten isolierenden Substrat (1) entfernt werden, während der Lichtstrahl zum Ausbilden der zweiten Ausnehmung zur Reihenverbindungsrichtung übertragen wird, um die zweite Ausnehmung (8b, 18b) auszubilden,
wobei bei der ersten Stufe die Übertragung des Lichtstrahls zum Ausbilden der ersten Ausnehmung derart gesteuert wird, dass ein Endbereich (8a1, 18a1, 18a3) der ersten Ausnehmung (8a, 18a), welcher auf einer vorgeschalteten Seite einer Richtung eines in den Abfolgen fließenden elektrischen Stroms auf einer vorgeschalteten Seite in Bezug auf die erste Elektrodenschicht (2) des fotoelektrischen Dünnschichtwandelelements (5) benachbart zu einer nachgeschalteten Seite des Parallelverbindungselements (5a) auszubilden ist, auf der vorgeschalteten Seite benachbart zu diesem Endbereich angeordnet ist, und
wobei bei der zweiten Stufe die Übertragung des Lichtstrahls zum Ausbilden der zweiten Ausnehmung so gesteuert wird, dass ein Endbereich (8b2, 18b2, 18b4) der zweiten Ausnehmung (8b, 18b), auf einer nachgeschalteten Seite der Stromrichtung auf einer nachgeschalteten Seite in Bezug auf die zweite Elektrode (4) des fotoelektrischen Dünnschichtwandelelements (5) benachbart zur vorgeschalteten Seite des Parallelverbindungselements (5b, 5c) auf der nachgeschalteten Seite welcher auszubilden ist, benachbart zu diesem Endbereich angeordnet ist.

14. Verfahren zum Herstellen einer integrierten Dünnschichtsolarbatterie nach Anspruch 12,
wobei der Abfolgenunterteilungsschritt eine erste Stufe des Aussendens eines Lichtstrahls zum Ausbilden einer zweiten Ausnehmung zum Ermöglichen, dass die fotoelektrische Wandlerschicht und die zweite Elektrodenschicht von dem transparenten isolierenden Substrat entfernt werden, während der Lichtstrahl zum Ausbilden der zweiten Ausnehmung zur Reihenverbindungsrichtung übertragen wird, um die zweite Ausnehmung auszubilden, sowie eine zweite Stufe des Aussendens eines Lichtstrahls zum Ausbilden einer ersten Ausnehmung aufweist zum Ermöglichen, dass die erste Elektrodenschicht von dem transparenten isolierenden Substrat entfernt wird, während der Lichtstrahl zum Ausbilden der ersten Ausnehmung zu Reihenverbindungsrichtung übertragen wird, um die erste Ausnehmung auszubilden,
wobei bei der ersten Stufe die Übertragung des Lichtstrahls zum Ausbilden der zweiten Ausnehmung so gesteuert wird, dass ein Endbereich (8b2, 18b2, 18b4) der zweiten Ausnehmung (8b, 18b), auf einer nachgeschalteten Seite einer Stromrichtung, wo ein Strom in den Abfolgen fließt, auf einer nachgeschalteten Seite in Bezug auf die zweite Elektrode (4) des fotoelektrischen Dünnschichtwandelelements benachbart zur vorgeschalteten Seite des Parallelverbindungselements (5b, 5c) auf der nachgeschalteten Seite welcher auszubilden ist, benachbart zu diesem Endbereich angeordnet ist, und
wobei bei der ersten Stufe die Übertragung des Lichtstrahls zum Ausbilden der ersten Ausnehmung derart gesteuert wird, dass ein Endbereich (8a1, 18a1, 18a3) der ersten Ausnehmung (8a, 18a), welcher auf einer vorgeschalteten Seite einer Richtung eines in den Abfolgen fließenden elektrischen Stroms auf einer vorgeschalteten Seite in Bezug auf die erste Elektrode (2) des fotoelektrischen Dünnschichtwandelelements benachbart zur nachgeschalteten Seite des Parallelverbindungselements (5a) auszubilden ist, auf der vorgeschalteten Seite benachbart zu diesem Endbereich angeordnet ist.

15. Verfahren zum Herstellen einer integrierten Dünnschichtsolarbatterie nach Anspruch 13 oder 14,
wobei
die Übertragung des Lichtstrahls zum Ausbilden der zweiten Ausnehmung derart gesteuert wird, dass ein Endbereich (8b1, 18be, 18b3) der zweiten Ausnehmung (8b, 18b), welche an einer vorgeschalteten Seite der Stromrichtung auszubilden ist, in einem Bereich zwischen einem Gebiet des fotoelektrischen Dünnschichtwandelelements (5) benachbart zur nachgeschalteten Seite des Parallelverbindungselements (5a, 5c) auf der vorgeschalteten Seite benachbart zu diesem Endbereich und einem Positionsabzweig in das Parallelverbindungselement (5b, 5c) auf der nachgeschalteten Seite um ein bestimmtes Maß angeordnet ist, und
die Übertragung des Lichtstrahls zum Ausbilden der ersten Ausnehmung derart gesteuert wird, dass der ein Endbereich (8a2, 18a2, 18a4) der ersten Ausnehmung (8a, 18a), welche an einer nachgeschalteten Seite der Stromrichtung auszubilden ist, in einem Bereich zwischen einem Gebiet des fotoelektrischen Dünnschichtwandelelements benachbart zur vorgeschalteten Seite des Parallelverbindungselements (5b, 5c) auf der nachgeschalteten Seite benachbart zu diesem Endbereich und einem Positionsabzweig in das Parallelverbindungselement (5b, 5c) auf der nachgeschalteten Seite um ein bestimmtes Maß angeordnet ist.

16. Verfahren zum Herstellen einer integrierten Dünnschichtsolarbatterie nach Anspruch 15,
wobei
die Übertragung des Lichtstrahls zum Ausbilden der zweiten Ausnehmung derart gesteuert wird, dass der Endbereich (8b1, 18b1, 18b3) der zweiten Ausnehmung (8b, 18b), welche auf der vorgeschalteten Seite der Stromrichtung auszubilden ist, ein Gebiet der Elementtrennungsausnehmung (9) benachbart zur nachgeschalteten Seite des Parallelverbindungselements auf der vorgeschalteten Seite benachbart zu diesem Endbereich oder ein Gebiet des Parallelverbindungselements auf der vorgeschalteten Seite erreicht, und
die Übertragung des Lichtstrahls zum Ausbilden der ersten Ausnehmung derart gesteuert wird, dass der Endbereich (8a2, 18a2, 18a4) der ersten Ausnehmung (8a, 18a), welche auf der nachgeschalteten Seite der Stromrichtung auszubilden ist, ein Gebiet der Elementtrennungsausnehmung (9) benachbart zur vorgeschalteten Seite des Parallelverbindungselements (5b, 5c) auf der nachgeschalteten Seite benachbart zu diesem Endbereich oder ein Gebiet des Parallelverbindungselements (5b, 5c) auf der nachgeschalteten Seite erreicht.

17. Verfahren zum Herstellen einer integrierten Dünnschichtsolarbatterie nach Anspruch 13 oder 14,
wobei beim Abfolgenunterteilungsschritt die Übertragung des Lichtstrahls zum Ausbilden der ersten Ausnehmung und des Lichtstrahls zum Ausbilden der zweiten Ausnehmung derart gesteuert wird, dass die gesamte erste Ausnehmung (8a) in einem inneren Bereich der zweiten Ausnehmung (8b) angeordnet wird.

18. Verfahren zum Herstellen einer integrierten Dünnschichtsolarbatterie nach Anspruch 12,
wobei ein Durchmesser des Lichtstrahls zum Ausbilden der ersten Ausnehmung 10 bis 1000 µm beträgt und ein Durchmesser des Lichtstrahls zum Ausbilden der zweiten Ausnehmung 10 bis 1000 µm beträgt.

19. Verfahren zum Herstellen einer integrierten Dünnschichtsolarbatterie nach Anspruch 12,
welches des Weiteren einen Schritt des elektrischen Verbindens der Stromsammelelektrode (6) auf der zweiten Elektrodenschicht (4) des Parallelverbindungselements (5a, 5b, 5c) aufweist.

## Revendications

1. Batterie solaire à couche mince intégrée, comprenant :
plusieurs chaînes (S) qui ont plusieurs éléments de conversion photoélectriques à couche mince (5) formés sur un substrat isolant transparent (1), les éléments de conversion photoélectriques à couche mince (5) étant reliés électriquement en série entre eux, étant précisé
que les éléments de conversion photoélectriques à couche mince (5) ont une première couche d'électrode transparente (2) appliquée par stratification sur le substrat isolant transparent (1), une couche de conversion photoélectrique (3) appliquée par stratification sur la première couche d'électrode (2), et une seconde couche d'électrode (4) appliquée par stratification sur la couche de conversion photoélectrique (3),
que lesdites chaînes (S) sont disposées parallèlement sur le même substrat isolant transparent (1) dans une direction perpendiculaire à la direction de montage en série, en passant sur une ou plusieurs rainures de séparation de chaînes (8) qui s'étendent dans la direction de montage en série,
que la rainure de séparation de chaînes (8, 18) comprend une première rainure (8a, 18a) qui est formée en enlevant la première couche d'électrode (2), et une seconde rainure (8b, 18b) qui est formée en enlevant la couche de conversion photoélectrique (3) et la seconde couche d'électrode (4) avec une largeur plus grande que celle de la première rainure (8a, 18a),
que les éléments de conversion photoélectriques à couche mince (5) prévus à n'importe quel endroit dans la direction de montage en série sont des éléments à montage en parallèle (5a, 5b, 5c) dans lesquels une partie de la couche de conversion photoélectrique (3) et de la seconde couche d'électrode (4) est enlevée par la rainure de séparation de chaînes, et le reste de la couche de conversion photoélectrique (3) et de la seconde couche d'électrode (4) est monté intégralement de manière à s'étendre dans la direction perpendiculaire à la direction de montage en série, et que les éléments à montage en parallèle (5a, 5b, 5c) relient électriquement les chaînes en parallèle.

2. Batterie solaire à couche mince intégrée selon la revendication 1, étant précisé
que la chaîne (S) a une rainure de séparation d'éléments (9) qui est formée en enlevant la seconde couche d'électrode (4) et la couche de conversion photoélectrique (3) entre les deux éléments de conversion photoélectriques à couche mince (5) voisins dans la direction de montage en série,
que la première couche d'électrode (2) d'un élément de conversion photoélectrique à couche mince a une section d'extension (2a) dont une extrémité traverse la rainure de séparation d'éléments (9) et s'étend jusqu'à une zone d'un autre élément de conversion photoélectrique à couche mince (5) voisin dans la direction de montage en série, et est isolée électriquement de la première couche d'électrode (2) d'un autre élément de conversion photoélectrique à couche mince (5) voisin dans la direction de montage en série, grâce à une ligne de séparation d'électrodes (10),
qu'une extrémité de la seconde couche d'électrode (4) d'un élément de conversion photoélectrique à couche mince (5) est reliée électriquement à la section d'extension (2a) de la première couche d'électrode (2) d'un autre élément de conversion photoélectrique à couche mince (5) voisin dans la direction de montage en série, par l'intermédiaire de la section conductrice (4a) qui traverse la couche de conversion photoélectrique (3),
qu'une partie d'extrémité (8a1, 18a1, 18a3) de la première rainure (8a, 18a) située sur un côté amont d'une direction d'un courant électrique qui passe dans les chaînes est disposée sur un côté amont par rapport à la première couche d'électrode (2) de l'élément de conversion photoélectrique à couche mince voisin du côté aval de l'élément à montage en parallèle (5a) situé sur le côté aval près de cette partie d'extrémité, et
qu'une partie d'extrémité (8b2, 18b2, 18b4) de la seconde rainure (8b, 18b) sur un côté aval de la direction du courant est disposée sur un côté aval par rapport à la seconde couche d'électrode (4) de l'élément de conversion photoélectrique à couche mince voisin du côté amont de l'élément à montage en parallèle (5b, 5c) situé sur le côté aval près de cette partie d'extrémité.

3. Batterie solaire à couche mince intégrée selon la revendication 2, étant précisé
qu'une partie d'extrémité (8b1, 18b1, 18b3) de la seconde rainure (8b, 18b) sur un côté amont de la direction du courant est disposée dans une plage entre une zone de l'élément de conversion photoélectrique à couche mince (5) voisin du côté aval de l'élément à montage en parallèle (5a, 5c) situé sur le côté amont près de cette extrémité, et une déviation de position dans l'élément à montage en parallèle (5a, 5c) situé sur le côté amont, suivant une dimension prédéterminée, et
qu'une partie d'extrémité (8a2, 18a2, 18a4) de la première rainure (8a, 18a) sur un côté aval de la direction du courant est disposée dans une plage entre une zone de l'élément de conversion photoélectrique à couche mince voisin du côté amont de l'élément à montage en parallèle (5b, 5c) situé sur le côté aval près de cette extrémité, et une position de dérivation dans l'élément à montage en parallèle (5b, 5c) situé sur le côté aval, suivant une dimension prédéterminée.

4. Batterie solaire à couche mince intégrée selon la revendication 3, étant précisé
que la partie d'extrémité (8b1, 18b1, 18b3) de la seconde rainure (8b, 18b) sur le côté amont de la direction du courant est disposée dans une zone de la rainure de séparation d'élément (9) voisine du côté aval de l'élément à montage en parallèle (5a, 5c) situé sur le côté amont près de cette partie d'extrémité, ou dans une zone de l'élément à montage en parallèle (5a, 5c) sur le côté amont, et
que la partie d'extrémité (8a2, 18a2, 18a4) de la première rainure (8a, 18a) sur le côté aval de la direction du courant est disposée dans une zone de la rainure de séparation d'éléments (9) voisine du côté amont de l'élément à montage en parallèle (5b, 5c) situé sur le côté aval près de cette partie d'extrémité, ou dans une zone de l'élément à montage en parallèle (5b, 5c) sur le côté aval.

5. Batterie solaire à couche mince intégrée selon la revendication 4, étant précisé que toute la première rainure (8a, 18a) est disposée dans une zone intérieure de la seconde rainure (8b, 18b).

6. Batterie solaire à couche mince intégrée selon la revendication 1, étant précisé qu'une électrode collectrice d'énergie (6, 7) est également connectée électriquement sur la seconde couche d'électrode (4) de l'élément à montage en parallèle (5a, 5b).

7. Batterie solaire à couche mince intégrée selon la revendication 6, étant précisé que l'électrode collectrice d'énergie comprend une première électrode collectrice d'énergie (6) et une seconde électrode collectrice d'énergie (7), et que la première électrode collectrice d'énergie (6) et la seconde électrode collectrice d'énergie (7) sont disposées sur la seconde couche d'électrode (4) des éléments à montage parallèle (5a, 5b) aux deux extrémités de la direction de montage en série dans les chaînes.

8. Batterie solaire à couche mince intégrée selon la revendication 7, étant précisé que l'électrode collectrice d'énergie a également une électrode collectrice d'énergie intermédiaire (14), et que l'électrode collectrice d'énergie intermédiaire (14) est disposée sur la seconde couche d'électrode (4) du ou des éléments à montage en parallèle (5c) entre les éléments à montage en parallèle (5a, 5b) sur les deux extrémités de la direction de montage en série dans les chaînes.

9. Batterie solaire à couche mince intégrée selon la revendication 1, étant précisé qu'une largeur de la première rainure (8a, 18a) est de 10 à 1000 µm et qu'une largeur de la seconde rainure (8b, 18b) est de 20 à 1500 µm.

10. Batterie solaire à couche mince intégrée selon la revendication 7, étant précisé
que plusieurs groupes comprenant des chaînes sont complètement isolés et séparés par au moins une rainure de séparation de chaînes (18b),
que les chaînes de chaque groupe sont reliées électriquement en parallèle par la première électrode collectrice d'énergie (6) et la seconde électrode collectrice d'énergie (7), et
que les groupes sont reliés électriquement en série.

11. Batterie solaire à couche mince intégrée selon la revendication 8, étant précisé
que les diodes de dérivation sont reliées électriquement en parallèle aux chaînes reliées électriquement en parallèle, et que les diodes de dérivation sont montées électriquement en série.

12. Procédé pour fabriquer une batterie solaire à couche mince intégrée, comprenant :
une étape de formation de chaîne de prédivision sur une surface d'un substrat isolant transparent (1), la chaîne de prédivision ayant plusieurs éléments de conversion photoélectriques à couche mince (5) reliés électriquement entre eux en série ; et
une étape de division de chaîne qui consiste à enlever une partie prédéterminée de la chaîne de prédivision en utilisant un faisceau lumineux, et à former une rainure de séparation de chaînes (8, 18) qui s'étend dans la direction de montage en série de manière à former plusieurs chaînes, étant précisé
que l'étape de formation de chaîne de prédivision comprend une étape de dépôt qui consiste à appliquer par stratification une première couche d'électrode (2), une couche de conversion photoélectrique (3) et une seconde couche d'électrode (4) sur la surface du substrat isolant transparent (1), dans cet ordre, de manière à former un film stratifié, et une étape qui consiste à enlever la seconde couche d'électrode (4) et la couche de conversion photoélectrique (3) du film stratifié pour former plusieurs rainures de séparation d'éléments (9) qui s'étendent dans une direction perpendiculaire à la direction de montage en série de manière à former les éléments de conversion photoélectrique à couche mince (5),
que la rainure de séparation de chaînes (8, 18) comprend une première rainure (8a, 18a) qui est formée en enlevant la première couche d'électrode (2), et une seconde rainure (8b, 18b) qui est formée en enlevant la couche de conversion photoélectrique (3) et la seconde couche d'électrode (4) avec une largeur plus grande que celle de la première rainure (8a, 18a), et
lors de l'étape de division de chaîne, la chaîne de prédivision est partiellement enlevée par un faisceau lumineux de sorte que la rainure de séparation de chaîne (8, 18) ne soit formée que sur une partie de la couche de conversion photoélectrique (3) et de la seconde couche d'électrode (4) de n'importe quels éléments de conversion photoélectriques à couche mince (5) s'étendant dans la direction perpendiculaire à la direction de montage en série, formant ainsi les chaînes disposées en parallèle dans la direction perpendiculaire à la direction de montage en série, et des éléments à montage en parallèle (5a, 5b, 5c) pour relier électriquement les chaînes en parallèle.

13. Procédé pour fabriquer une batterie solaire à couche mince intégrée selon la revendication 12, étant précisé
que l'étape de division de chaîne comprend un premier stade qui consiste à émettre un premier faisceau lumineux de formation de rainure pour permettre à la première couche d'électrode (2), à la couche de conversion photoélectrique (3) et à la seconde couche d'électrode (4) d'être enlevées du substrat isolant transparent (1), en transférant le premier faisceau lumineux de formation de rainure dans la direction de montage en série de manière à former la première rainure (8a, 18a), et un second stade qui consiste à émettre un second faisceau lumineux de formation de rainure pour permettre à la couche de conversion photoélectrique (3) et à la seconde couche d'électrode (4) d'être enlevées du substrat isolant transparent (1), en transférant le second faisceau lumineux de formation de rainure dans la direction de montage en série de manière à former la seconde rainure (8b, 18b),
que lors du premier stade, le transfert du premier faisceau lumineux de formation de rainure est commandé de telle sorte qu'une partie d'extrémité (8a1, 18a1, 18a3) de la première rainure (8a, 18a) à former sur un côté amont d'une direction de courant dans laquelle un courant électrique passe dans les chaînes soit disposée sur un côté amont par rapport à la première couche d'électrode (2) de l'élément de conversion photoélectrique à couche mince (5) voisin d'un côté aval de l'élément à montage en parallèle (5a, 5c) situé sur le côté aval près de cette partie d'extrémité, et
que lors du second stade, le transfert du second faisceau lumineux de formation de rainure est commandé de telle sorte qu'une partie d'extrémité (8b2, 18b2, 18b4) de la seconde rainure (8b, 18b) à former sur un côté aval de la direction du courant soit disposée sur un côté aval par rapport à la seconde électrode (4) de l'élément de conversion photoélectrique à couche mince (5) voisin du côté amont de l'élément à montage en parallèle (5b, 5c) situé sur le côté aval près de cette partie d'extrémité.

14. Procédé pour fabriquer une batterie solaire à couche mince intégrée selon la revendication 12, étant précisé
que l'étape de division de chaîne comprend un premier stade qui consiste à émettre un second faisceau lumineux de formation de rainure pour permettre à la couche de conversion photoélectrique et à la seconde couche d'électrode d'être enlevées du substrat isolant transparent, en transférant le second faisceau lumineux de formation de rainure dans la direction de montage en série de manière à former la seconde rainure, et un second stade qui consiste à émettre un premier faisceau lumineux de formation de rainure pour permettre à la première couche d'électrode d'être enlevée du substrat isolant transparent, en transférant le premier faisceau lumineux de formation de rainure dans la direction de montage en série de manière à former la première rainure,
que lors du premier stade, le transfert du second faisceau lumineux de formation de rainure est commandé de telle sorte qu'une partie d'extrémité (8a2, 18a2, 18a4) de la seconde rainure (8b, 18b) à former sur un côté amont d'une direction de courant dans laquelle un courant électrique passe dans les chaînes soit disposée sur un côté aval par rapport à la seconde électrode (4) de l'élément de conversion photoélectrique à couche mince voisin d'un côté amont de l'élément à montage en parallèle (5b, 5c) situé sur le côté aval près de cette partie d'extrémité, et
que lors du second stade, le transfert du premier faisceau lumineux de formation de rainure est commandé de telle sorte qu'une partie d'extrémité (8a1, 18a1, 18a3) de la première rainure (8a, 18a) à former sur un côté amont de la direction du courant soit disposée sur un côté amont par rapport à la première électrode (2) de l'élément de conversion photoélectrique à couche mince voisin du côté aval de l'élément à montage en parallèle (5b, 5c) situé sur un côté amont près de cette partie d'extrémité.

15. Procédé pour fabriquer une batterie solaire à couche mince intégrée selon la revendication 13 ou 14, étant précisé
que le transfert du second faisceau lumineux de formation de rainure est commandé de telle sorte que la partie d'extrémité (8b1, 18b1, 18b3) de la seconde rainure (8b, 18b) à former sur le côté amont de la direction du courant soit disposée dans une plage entre une zone de l'élément de conversion photoélectrique à couche mince (5) voisin du côté aval de l'élément à montage en parallèle (5a, 5c) situé sur le côté amont près de cette extrémité, et une déviation de position dans l'élément à montage en parallèle (5a, 5c) situé sur le côté amont, suivant une dimension prédéterminée, et
que le transfert du premier faisceau lumineux de formation de rainure est commandé de telle sorte que la partie d'extrémité (8a2, 18a2, 18a4) de la première rainure (8a) à former sur le côté aval de la direction du courant soit disposée dans une plage entre une zone de l'élément de conversion photoélectrique à couche mince (5) voisin du côté amont de l'élément à montage en parallèle (5b, 5c) situé sur le côté aval près de cette partie d'extrémité, et une position de dérivation dans l'élément à montage en parallèle (5b, 5c) situé sur le côté aval, suivant une dimension prédéterminée.

16. Procédé pour fabriquer une batterie solaire à couche mince intégrée selon la revendication 15, étant précisé
que le transfert du second faisceau lumineux de formation de rainure est commandé de telle sorte que la partie d'extrémité (8b1, 18b1, 18b3) de la seconde rainure (8b, 18b) à former sur le côté amont de la direction du courant atteigne une zone de la rainure de séparation d'éléments (9) voisine du côté aval de l'élément à montage en parallèle situé sur le côté amont près de cette partie d'extrémité, ou une zone de l'élément à montage en parallèle situé sur le côté amont, et
que le transfert du premier faisceau lumineux de formation de rainure est commandé de telle sorte que la partie d'extrémité (8a2, 18a2, 18a4) de la première rainure (8a, 18a) à former sur le côté aval de la direction du courant atteigne une zone de la rainure de séparation d'éléments (9) voisine du côté amont de l'élément à montage en parallèle (5a, 5c) situé sur le côté aval près de cette partie d'extrémité, ou une zone de l'élément à montage en parallèle (5a, 5c) situé sur le côté aval.

17. Procédé pour fabriquer une batterie solaire à couche mince intégrée selon la revendication 13 ou 14, étant précisé que lors de l'étape de division de chaîne, le transfert du premier faisceau lumineux de formation de rainure et du second faisceau lumineux de formation de rainure est commandé de telle sorte que toute la première rainure (8a) soit disposée dans une zone intérieure de la seconde rainure (8b).

18. Procédé pour fabriquer une batterie solaire à couche mince intégrée selon la revendication 12, étant précisé qu'un diamètre du premier faisceau lumineux de formation de rainure est de 10 à 1000 µm et qu'un diamètre du second faisceau lumineux de formation de rainure est de 10 à 1000 m.

19. Procédé pour fabriquer une batterie solaire à couche mince intégrée selon la revendication 12, comprenant également une étape qui consiste à connecter électriquement l'électrode collectrice d'énergie (6) sur la seconde couche d'électrode (4) de l'élément à montage en parallèle (5a, 5b, 5c).
